# EUROPEAN PATENT APPLICATION

(11) **EP 4 550 007 A1**
(43) Date of publication of application: **07.05.2025**
(21) Application number: 23831177.3
(22) Date of filing: 19.06.2023
(51) Int. Cl.: G01V 3/12, G01R 29/08, H01Q 9/16, H02J 7/00, H02J 50/20, H03H 5/02

(54) **ELECTRICAL FIELD SENSOR APPARATUS**

(30) Priority: 29.06.2022 JP 2022104134; 17.02.2023 JP 2023023268
(71) Applicant: Sony Semiconductor Solutions Corporation, Atsugi-shi, Kanagawa 243-0014 (JP)
(72) Inventor: YOSHINO, Yoshitaka, Atsugi-shi, Kanagawa 243-0014 (JP)
(74) Representative: D Young & Co LLP
(86) International application number: PCT/JP2023/022562
(87) International publication number: WO 2024/004731

(57) **Abstract**

An electric field sensor device includes: an antenna device that has a dipole structure that receives an electric field, the antenna device including a first antenna element connected to or in contact with a ground and a conductor existing with a certain resistance value, and a second antenna element grounded to an earth ground or not grounded to an earth ground; a rectifier circuit that rectifies a signal induced in the antenna device; and a detection unit that detects a level of an output voltage of the rectifier circuit. The detection unit detects a change in level of the output voltage caused when the first antenna element or the second antenna element not grounded to an earth ground is spatially coupled to or in contact with another conductor different from the conductor, and detects a state or a situation of the other conductor.

## Description

### TECHNICAL FIELD

The present technology relates to an electric field sensor device using an antenna device having an energy harvesting function.

### BACKGROUND ART

Converting energy of electromagnetic waves present around us into power (energy harvesting) has been considered. In the case of environmental power generation, the current flowing through the antenna to the circuit is rectified into direct current and converted into electric energy. A diode is used to rectify electromagnetic waves into direct current. A rectifier circuit-equipped antenna is called a rectenna.

Patent Document 1 describes a person detection device using an antenna using a rectenna. This person detection device is a detection device that detects a person by a fluctuation of an electromagnetic wave existing in an indoor environment. The person detection device includes a current colleting means that electrically acquires the electromagnetic wave that exists in the indoor environment, and a rectifying and boosting unit that rectifies and boosts power of the electromagnetic wave existing in the indoor environment and electrically acquired by the current collecting means to direct current. The distance between the current collecting means and a human body that is a fluctuation factor of the electromagnetic wave existing in the indoor environment is obtained from a change in output voltage of the rectifying and boosting means. Furthermore, the current collecting means and the rectifying and boosting means are operated by the power of the electromagnetic wave that exists in the indoor environment.

The person detection device described in Patent Document 1 described above detects a human body using a planar antenna having a planar shape as a current collecting means, but in this case, the antenna size is limited, and since there is only one antenna, there is a problem that only a very low voltage (mW) can be obtained from the antenna sensor alone even though a booster circuit or a ground of a measuring instrument functions as an antenna.

The inventors of the present application has proposed an antenna device capable of obtaining larger reception power by taking in electric field energy of a quasi-electrostatic field (near field) in addition to a wide range of radio waves with a configuration different from that of the antenna device that uses a reception antenna of the related art and converts energy of radio waves into power (see Patent Documents 2 and 3).

### CITATION LIST

### PATENT DOCUMENT

Patent Document 1: Japanese Patent Application Laid-Open No. 2017-146203
Patent Document 2: WO2021-261075
Patent Document 3: WO2021-261076

### SUMMARY OF THE INVENTION

### PROBLEMS TO BE SOLVED BY THE INVENTION

In the device described in Patent Document 1 described above, since a relatively small copper plate is used as a current collecting means, only a small AC signal can be obtained, and it is necessary to use a rectifying and boosting circuit such as a Cockcroft-Walton circuit. Furthermore, what is described in Patent Document 1 is limited to the use of detecting a person in an indoor environment.

The present technology solves such a problem, and makes it possible to take in large power without using a booster circuit by increasing an antenna size using a large metal conductor (for example, a car, a notebook computer, a television, a refrigerator, an automatic cash deposit and payment machine, and the like) as one antenna element.

In particular, in Patent Document 1, although it is limited to the indoor environment, various electric fields such as a quasi-electrostatic field and an electromagnetic wave are always generated in a space including the outdoors, and the present technology can also take in electric field energy in such a space.

An object of the present technology is to provide an electric field sensor device that can be applied not only to an indoor environment but also to detection of metal conductors such as a human body, an organism (an animal and a plant other than a human), and a vehicle, and can induce a large voltage.

### SOLUTIONS TO PROBLEMS

An electric field sensor device according to the present technology includes:
an antenna device that has a dipole structure that receives an electric field, the antenna device including a first antenna element connected to or in contact with a ground and a conductor existing with a certain resistance value, and a second antenna element grounded to the ground or not grounded;
a rectifier circuit that rectifies a signal induced in the antenna device; and
a detection unit that detects a level of an output voltage of the rectifier circuit.

The detection unit detects a change in level of the output voltage caused when the first antenna element or the ungrounded second antenna element is spatially coupled to or in contact with another conductor different from the conductor, and detects a state or a situation of the other conductor.

### BRIEF DESCRIPTION OF DRAWINGS

Fig. 1 is a block diagram of an example of an electric field sensor device according to the present technology.
Figs. 2A, 2B, and 2C are a plan view and cross-sectional views of an example of an antenna device.
Figs. 3A and 3B are a plan view and a cross-sectional view of another example of the antenna device.
Fig. 4 is a schematic diagram for explaining operation of the antenna device.
Figs. 5A, 5B, and 5C are schematic diagrams for explaining a specific example of the antenna device.
Fig. 6 is a connection diagram illustrating an example of a configuration of an electric field sensor device.
Fig. 7 is a graph for explaining characteristics of a diode of a rectifier circuit.
Fig. 8 is a connection diagram in a case where an output voltage of the rectifier circuit is measured.
Fig. 9 is a connection diagram of an example of a rectifier circuit using a MOSFET instead of a diode.
Fig. 10 is a schematic diagram for explaining an example of the electric field sensor device.
Fig. 11 is a schematic diagram for explaining another example of the electric field sensor device.
Fig. 12 is a connection diagram illustrating an example of a configuration for measuring a voltage induced in the electric field sensor device.
Fig. 13 is a schematic diagram illustrating an example of a specific configuration for measuring a voltage induced in the electric field sensor device.
Fig. 14 is a graph illustrating a change in voltage with respect to a value of ground resistor of the electric field sensor device.
Fig. 15 is a connection diagram of an example of a high-pass filter connected to an earth line.
Fig. 16 is a graph illustrating an example of frequency characteristics of the high-pass filter.
Fig. 17 is a connection diagram of an example of a parallel resonance circuit connected to an earth line.
Fig. 18 is a graph illustrating an example of frequency characteristics of the parallel resonance circuit.
Fig. 19 is a connection diagram illustrating a configuration in which a high-pass filter and a parallel resonance circuit are combined.
Figs. 20A, 20B, and 20C are block diagrams illustrating a plurality of circuit examples.
Fig. 21 is a connection diagram illustrating a configuration example in which two antenna elements are separated by a resistor.
Fig. 22 is a connection diagram illustrating a configuration example in which two antenna elements are separated by a filter.
Figs. 23A, 23B, 23C, and 23D are connection diagrams illustrating a plurality of examples of a filter.
Figs. 24A, 24B, 24C, and 24D are schematic diagrams illustrating four configuration examples of the electric field sensor device according to the present technology.
Fig. 25 is a schematic diagram illustrating a configuration of an embodiment in which the present technology is applied to a human sensor.
Fig. 26 is a flowchart used to describe the operation of the human sensor illustrated in Fig. 25.
Fig. 27 is a schematic diagram illustrating another configuration example of the embodiment in which the present technology is applied to a human sensor.
Fig. 28 is a schematic diagram illustrating a configuration of an embodiment in which the present technology is applied to a vehicle sensor.
Fig. 29 is a flowchart used to describe the operation of the vehicle sensor illustrated in Fig. 28.
Fig. 30 is a schematic diagram illustrating a configuration of an embodiment in which the present technology is applied to a human sensor using a fluorescent lamp device.
Fig. 31 is a flowchart used to describe the operation of the human sensor illustrated in Fig. 30.
Fig. 32 is a schematic diagram illustrating a configuration of an embodiment in which the present technology is applied to a human sensor of a warm-water cleaning toilet seat.
Figs. 33A and 33B are schematic diagrams illustrating a configuration of another embodiment in which the present technology is applied to a human sensor of a warm-water cleaning toilet seat.
Fig. 34 is a schematic diagram illustrating a configuration of still another embodiment in which the present technology is applied to a human sensor of a warm-water cleaning toilet seat.
Fig. 35 is a flowchart used to describe the operation of the human sensor illustrated in Fig. 34.
Fig. 36 is a schematic diagram illustrating a front surface of a configuration of an embodiment in which the present technology is applied to a human sensor of an automatic cash deposit and payment machine.
Fig. 37 is a schematic diagram illustrating a side surface of a configuration of an embodiment in which the present technology is applied to a human sensor of an automatic cash deposit and payment machine.
Fig. 38 is a flowchart used to describe the operation of the human sensor illustrated in Figs. 36 and 37.
Fig. 39 is a schematic diagram illustrating a configuration of an embodiment in which the present technology is applied to a human sensor of a door of a vehicle.
Fig. 40 is a cross-sectional view illustrating an example of a partial configuration of Fig. 39.
Fig. 41 is a connection diagram of a part of a circuit portion of the configuration of Fig. 39.
Fig. 42 is a flowchart used to describe the operation of the human sensor illustrated in Figs. 39, 40, and 41.
Fig. 43 is a schematic diagram illustrating a configuration of an embodiment in which the present technology is applied to a human sensor in an office.
Figs. 44A and 44B are schematic diagrams used to describe the human sensor illustrated in Fig. 43.
Fig. 45 is a flowchart used to describe the operation of the human sensor illustrated in Figs. 43, 44A, and 44B.
Fig. 46 is a schematic diagram illustrating a configuration of an embodiment in which the present technology is applied to an unmanned aerial vehicle.
Fig. 47 is a schematic diagram illustrating a simplified configuration of Fig. 46.
Fig. 48 is a schematic diagram illustrating a modification of the configuration of Fig. 47.
Fig. 49 is a flowchart used to describe the operation of the sensor of the unmanned aerial vehicle illustrated in Figs. 47 and 48.
Fig. 50 is a schematic diagram illustrating a configuration of an embodiment in which the present technology is applied to a transfer robot.
Fig. 51 is a schematic diagram illustrating a modification of the configuration of Fig. 50.
Fig. 52 is a flowchart used to describe the operation of the sensor illustrated in Figs. 50 and 51.
Fig. 53 is a schematic diagram illustrating a configuration of an embodiment in which the present technology is applied to a human sensor using a potted plant.
Fig. 54 is a schematic diagram used to describe the human sensor illustrated in Fig. 53.
Fig. 55 is a flowchart used to describe the operation of the human sensor illustrated in Figs. 53 and 54.
Fig. 56 is a flowchart used to describe an operation in a case where the configuration illustrated in Figs. 53 and 54 is used as a sensor for a water supply state.
Fig. 57 is a schematic diagram illustrating a configuration of an embodiment in which the present technology is applied to a sensor of the amount of moisture in the ground.
Fig. 58 is a schematic diagram illustrating a configuration of an embodiment in which the present technology is applied to a hand sensor for motion control of a headphone.
Fig. 59 is a flowchart used to describe the operation of the hand sensor illustrated in Fig. 58.

### MODE FOR CARRYING OUT THE INVENTION

The embodiments described below are preferred specific examples of the present technology, and various technically preferable limitations are given. However, the scope of the present technology is not limited to these embodiments unless there is a description to limit the present technology in the following description. Furthermore, in the following description, the same names and reference numerals indicate the same or similar constituent elements, and redundant description will be omitted as appropriate.

Various electric fields such as a quasi-electrostatic field and an electromagnetic wave are constantly generated not only in the room but also in a space including the outdoors, and an energy collecting unit is known in order to take in electric field energy in such a space. The quasi-electrostatic field is a voltage phenomenon that does not have a property of propagating like a radiated electromagnetic field, a so-called radio wave, and is distributed like electrostatic charging in the vicinity of a person, a vehicle, or a substance. The electrostatic field is regarded as having no time change, whereas the quasi-electrostatic field has a frequency component and has a time change.

In a case where the conductor exists in the space with the ground (earth) at a constant potential, the conductor and a human body, an organism (an animal and a plant other than a human), or a product metal portion are spatially coupled or brought into contact with each other, and a voltage change is induced by a degree of the coupling or the contact. By detecting the change, it is possible to detect the presence or absence (distance) of a conductor coupled or in contact with a human body, an organism (an animal and a plant other than a human), a car, a bicycle, a train, or the like, and the type (whether a person is approaching, a car is approaching, or the like) of the conductor.

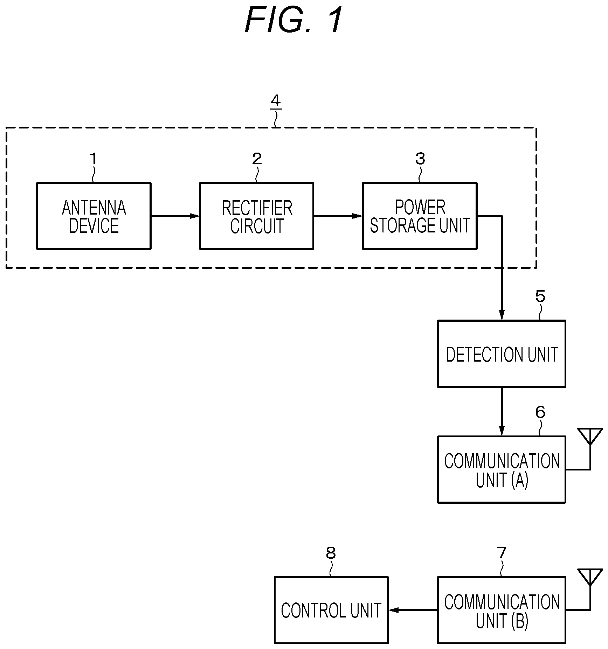

Fig. 1 is a block diagram schematically illustrating an electric field sensor device according to the present technology. An energy collecting unit (hereinafter, appropriately referred to as a harvester) 4 including an antenna device 1, a rectifier circuit 2, and a power storage unit 3 is provided. The harvester 4 is a device that extracts electric field energy existing in a space from a metal and outputs the energy as electric power. The harvester 4 includes the antenna device 1 as a current collector, the rectifier circuit 2, and the power storage unit 3 that smooths and stores an output of the rectifier circuit 2.

The output voltage obtained from the power storage unit 3 is supplied to a detection unit 5. The detection unit 5 detects a change in voltage supplied from the harvester 4 and generates a sensor output. The detection unit 5 includes an A/D converter, a microcomputer, and the like. The sensor output output from the detection unit 5 is supplied to a communication unit 6 (A). The communication unit (A) 6 transmits the sensor output to the other communication unit (B) 7 by wireless or wired communication. The sensor output received by the communication unit (B) 7 is supplied to a control unit 8. The control unit 8 controls the target device according to the sensor output. Note that the detection unit 5 may be connected to the subsequent stage of the communication unit (B) 7, the voltage output from the power storage unit 3 may be converted into digital data and supplied to the communication unit, and the received digital data may be determined by the detection unit.

Moreover, the antenna device 1 will be described. Electric field energy is induced in a product metal portion (iron, aluminum, copper, metal alloy, or the like) of an industrial product, a vehicle, a vending machine, a refrigerator, a microwave oven, a metal rack, a guardrail, a mail post, a traffic light, or the like existing in the vicinity. By using such a product metal portion as an antenna, a radio wave in the space and electric field energy of a quasi-electrostatic field (near field) can be collected. That is, when metal is present in an electrically floating state, AC power of various frequencies (AC current) flows on a metal surface. Therefore, this metal is regarded as an antenna, and this power can be efficiently converted into energy. Note that the product metal portion is a metal portion other than an industrial product designed as an antenna.

In an input terminal portion that is in contact with or connected to the product metal portion and is for using the product metal portion itself as an antenna, the impedance for reception is preferably high in connection with the rectifier circuit in a subsequent stage. In particular, the input terminal portion is connected in series without providing a matching circuit in accordance with the frequency. The rectifier circuit rectifies an output signal of the antenna with a diode having a very small reverse current with respect to a forward current. Therefore, in addition to the radio wave, it is possible to efficiently receive power of a quasi-electrostatic field (near field) which is not a radio wave having a frequency of 50/60 Hz leaking from a very small power supply.

The antenna device 1 of the harvester 4 has a dipole structure including two antenna elements. A first antenna element is a conductor electrically connected to a product metal portion itself or the product metal portion of a car, a refrigerator, a television, a notebook computer (hereinafter, referred to as a notebook PC), an unmanned aerial vehicle (hereinafter, referred to as a drone as appropriate), an automatic cash deposit and payment machine (hereinafter, referred to as an automatic teller machine (ATM) as appropriate), a train, or the like.

A second antenna element is an electrode, a copper foil pattern, a coil, or the like formed on a substrate. Furthermore, by connecting to the ground with a cable, it is possible to enhance coupling with the ground and to increase a voltage generated in the antenna device. In the following description, an antenna element that is in contact with or connected to a product metal portion, which is a conductor, is referred to as a first antenna element, and an antenna element that is not in contact with or connected to the product metal portion is referred to as a second antenna element.

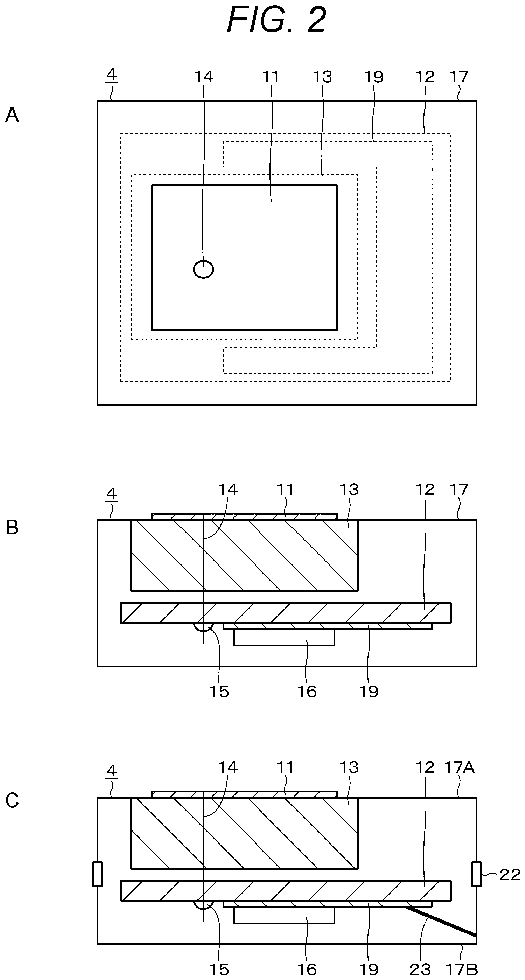

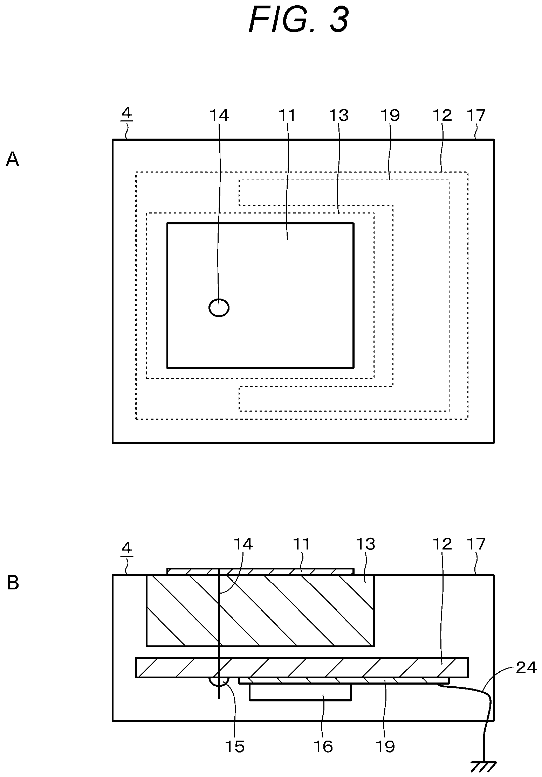

For understanding of the antenna device 1 of the harvester 4, an example of the configuration of the antenna device 1 will be described with reference to Figs. 2A (plan view), 2B (cross-sectional view), 2C (cross-sectional view), 3A (plan view), and 3B (cross-sectional view). As illustrated in Figs. 2A, 2B, 2C, 3A, and 3B, a conductive member 11 of a plate shape (patch shape) is provided as the first antenna element that is in contact with or connected to the product metal portion.

The conductive member 11 has a plate shape including a conductor such as gold, silver, aluminum, copper, iron, nickel, an alloy, or the like. The contact surface of the conductive member 11 with the metal may be coated with a resin. The conductive member 11 has a shape such as a linear shape, a pin shape, a hemispherical shape, or an uneven shape in accordance with the shape of the product metal portion. The product metal portion and the conductive member 11 are brought into contact with or connected to each other by a method such as welding, mechanical coupling (caulking or the like), adhering with a conductive adhesive, or bonding to an iron material or the like using magnetism of a magnet or the like.

Furthermore, as the conductive member 11, for example, a conductive resin, a conductive rubber, or the like in which carbon, metal, or the like is blended may be used. By using the conductive resin, for example, electrodes of various shapes can be easily formed. Furthermore, by using the conductive rubber, an electrode that can be elastically deformed, an electrode having high adhesion, and the like can be configured. In addition, the material of the conductive member 11 is not limited, and the materials described above may be used alone, or the electrodes may be configured by combining the respective materials.

In Figs. 2B and 2C, for example, a plate-shaped (patch-shaped) conductive member 11 and a device board (circuit board) 12 including a copper foil pattern as the second antenna element are arranged to face each other, and a dielectric plate 13 is interposed between the conductive member 11 and the device board 12. The space between the conductive member 11 and the device board 12 may be formed without providing the dielectric plate 13.

In order to electrically connect the conductive member 11 and the device board 12, one end of the conductive member 11 and one end of a conductive pin 14 are electrically connected, and the other end of the conductive pin 14 penetrates the device board 12 and is soldered to the signal path electrode on the back surface of the device board 12. The antenna device 1 includes the conductive member 11 and a ground electrode 19 formed of the copper foil pattern of the device board 12. The ground electrode 19 is the second antenna element. The antenna device 1 has a structure of a T-type antenna using a flat plate as an antenna element. A connection portion between the signal path electrode of the device board 12 and the conductive pin 14 serves as a feeding point 15 of the antenna.

A circuit unit 16 is provided on, for example, the back surface of the device board 12. The circuit unit 16 includes the rectifier circuit 2 and the power storage unit 3 illustrated in Fig. 1. Moreover, the detection unit 5 and the communication unit 6 may be configured as the circuit unit 16.

The antenna device having the above-described configuration is housed in a case 17. The contact surface of the case 17 other than the conductive member 11 includes an insulating material such as resin. Furthermore, a case side surface, a case opposite surface, and the like other than the contact surface with the metal that takes in energy also include an insulating material.

Fig. 2C illustrates a configuration in which the case 17 includes a case 17A including a non-metal such as resin or the like and a case 17B including a metal. The ground electrode 19 on either the upper or lower surface of the device board 12 and the case 17B may be electrically connected to each other. That is, the case 17A including an insulating material on which the conductive member 11 is provided and the case 17B including a metal material constituting the opposite surface may be connected by a connection unit 22 such as a screw, and the case 17B and the ground electrode 19 of the device board 12 may be connected by a wire 23.

Furthermore, as illustrated in Figs. 3A and 3B, an insulated covered cable 24 may be further connected to the ground electrode 19 including a copper foil pattern of the device board 12 by solder or the like to be grounded to the earth ground. Note that the conductive member 11 described above is configured in a plate shape and is configured to be in contact with or connected to the product metal portion. However, the product metal portion itself may be used as the conductive member 11, and the conductive member 11 and the feeding point 15 may be directly connected to each other by using a coated cable or the like insulated from the product metal portion.

There is a great deal of electric field energy around us, which can be divided into low frequency components and high frequency components. For example, a leakage electric field (50 Hz/60 Hz) from a home AC power supply, noise present in the vicinity of a personal computer, a voltage generated when a person walks, and the like are low frequency components. These are referred to as quasi-electrostatic fields (near field). On the other hand, radio broadcasting (AM/FM), television broadcasting, mobile phone radio waves, and the like are high frequency components. These are referred to as radio waves (far field).

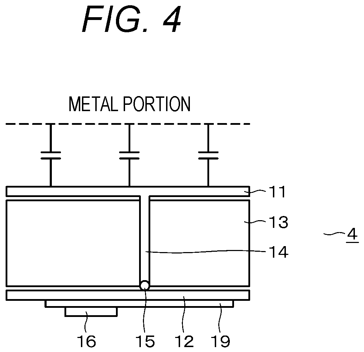

As illustrated in Fig. 4, the conductive member 11 of the antenna device 1 is brought into contact with the product metal portion. The conductive member 11 is attached to the product metal portion. Since the product metal portion is used as an antenna, the antenna device 1 can take in energy of both a quasi-electrostatic field such as noise which is a leakage current and a radio wave such as a broadcast wave.

For the antenna device 1, it is preferable that the conductive member 11 is directly connected to the product metal portion, but in this example, the antenna element is basically in surface contact to increase the capacity. It is sufficient that it is in contact with or connected to the metal portion. In the case off contacting, it may be fitted in a pin structure, a hemispherical shape, or an uneven shape other than a planar shape. In the case of connecting, it may be connected directly by screwing, soldering, welding, or the like or via an insulator (or air) such as an insulating covered cable or conductive rubber. The antenna device 1 including the conductive member 11 in contact with metal and the ground electrode 19 of the device board 12, or a separate electrode can receive electric field energy and generate electric power. Note that in a case where the conductive member 11 is capacitively coupled to a metal even if a space or an insulator is interposed, the size of the first antenna element can be increased.

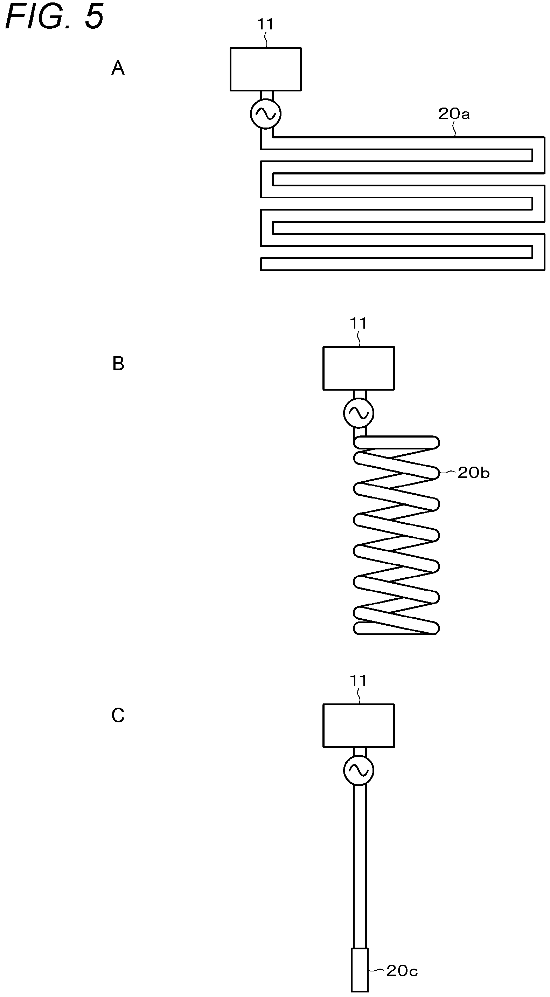

Other examples of the second antenna element formed on the substrate are illustrated in Figs. 5A, 5B, and 5C. Fig. 5A illustrates a configuration of a meander antenna 20a, and Fig. 5B illustrates a configuration of a coil 20b. The coil 20b may be configured as a chip coil. Fig. 5C illustrates a configuration in which an inductor 20c is provided at the tip portion. These configurations can reduce the occupation area, increase the antenna length, and increase the induction voltage. In addition, the second antenna element may be configured as a platelike antenna having broadband characteristics, and can be used by a combination of the illustrated antennas or an appropriate combination with the above-described antenna.

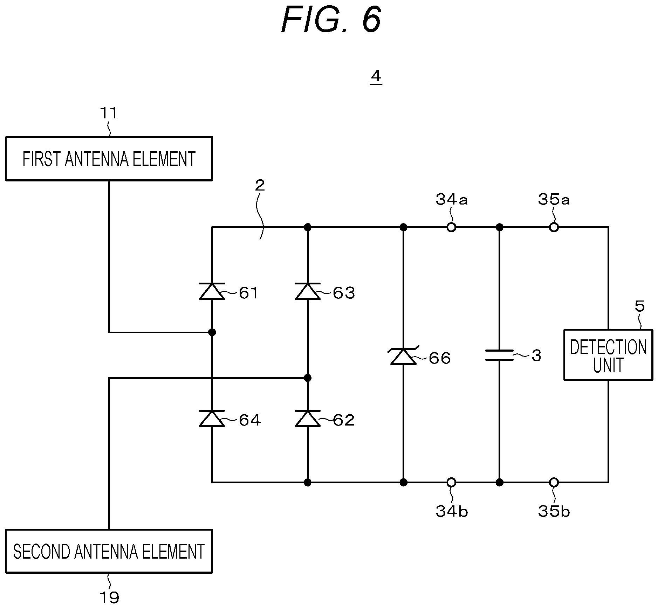

An example of the configuration of the harvester 4 is illustrated in Fig. 6. In the case of using a small voltage as in the harvester, rectification can be performed by a normal rectifier circuit, but a certain level of voltage is required in order to store energy quickly. Furthermore, in terms of efficiency, since the full-wave rectifier circuit can increase the voltage of the AC signal and take in all, even when the loss of the diode is included in the diode adopted for rectification, the full-wave rectifier circuit is preferably used. However, a half-wave rectifier circuit, a voltage doubler circuit, a Cockcroft-Walton circuit, or the like may be used as the rectifier circuit 2.

In the rectifier circuit 2, it is important that the leakage current of the diode at the time of reverse bias is very small. In a case where there is a leakage current, a full-wave rectifier circuit is suitable. As illustrated in Fig. 6, diodes 61 and 64 are connected in series, and diodes 63 and 62 are connected in series. A connection point of an anode of the diode 61 and a cathode of the diode 64 is connected to the conductive member 11, and a connection point of an anode of the diode 63 and a cathode of the diode 62 is connected to the ground electrode 19 as the second antenna element.

A cathode of the diode 61 and a cathode connection point of the diode 63 are connected to one output terminal 34a, and an anode of the diode 64 and an anode connection point of the diode 62 are connected to the other output terminal 34b. An electrostatic countermeasure varistor 66 (for example, a Zener diode) is connected in parallel between the output terminals 34a and 34b. The power storage unit (capacitor) 3 is connected in parallel between the output terminals 34a and 34b. The output terminals 35a and 35b are led out from both ends of the power storage unit 3, and the detection unit 5 is connected between the output terminals 35a and 35b.

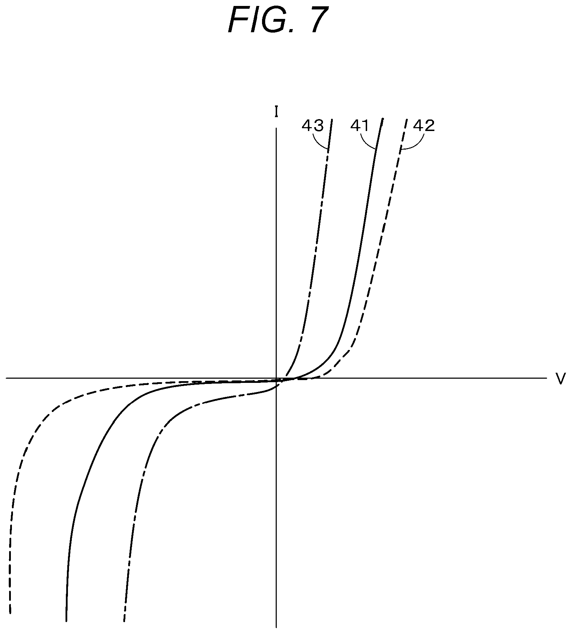

Note that, although it is configured by a discrete diode, it may be configured by a dedicated IC. Fig. 7 and Table 1 illustrates results of measurement of a forward voltage Vf and a reverse current Is of the diode used in the rectifier circuit 2. The diode product number 1N60 has been measured using silicon and germanium products, and the other product number ISS108 has been evaluated using germanium products manufactured by different manufacturers. In Fig. 7, a curve 42 is a characteristic of 1N60 (silicon), a curve 41 is a characteristic of 1N60 (germanium), and a curve 43 is a characteristic of ISS108 (germanium).

**[Table 1]**

| | Temperature | | Rectification in Metal Antenna |
|---|---|---|---|
| | Forward Voltage Vf [mV] | Reverse Current Is [µA] | |
| 1N60 (Silicon) | 367 | 1 | ○ |
| 1N60 (Germanium) | 303 | 7 | × |
| 1SS108 | 162 | 26 | × |

A current flowing when a voltage is applied in the reverse direction of the diode is the reverse current Is. The measurement data in Table 1 is data when 10 V is added in the reverse direction of the diode. The forward voltage Vf is a voltage at which a forward current (1 mA) starts to flow through the diode.

In a case where the output of the antenna unit 1 described above is rectified, it has been found that the diode 1N60 (silicon) in which the current does not flow in the reverse direction can take in power more than the diode in which the voltage at which the current starts to flow in the forward direction is low. The rectified input is an alternating current, and the reverse current Is when the forward voltage Vf of the diode is applied in the reverse direction is data of 10 V in Table 1. Therefore, when the reverse current Is when the same voltage as Vf is applied in the reverse direction is calculated from the data, 1N60 (silicon) is 0.036 µA, 1N60 (germanium) is 0.21 µA, and ISS108 (germanium) is 0.5 µA. Thus, the ratio of the reverse current Is at the forward current (1 mA)/forward voltage Vf is calculated to be 1/27778 for 1N60 (silicon), 1/4762 for 1N60 (germanium), and 1/2000 for ISS108 (germanium). That is, for the diode used in the rectifier circuit 2, the above-described ratio needs to be larger than about 4700 times, and preferably, the above-described ratio is 10,000 or more. As a result, among the three diodes mentioned as examples, 1N60 (silicon) has the most suitable characteristics.

Moreover, considering the characteristics of the diode, the reverse current Is when applied in the reverse direction is preferably small, and when the reverse resistance value is calculated using data of 10 V, 1N60 (silicon) is 100 MΩ, 1N60 (germanium) is 1.43 MΩ, and ISS108 (germanium) is 0.38 MΩ. That is, the resistance value for preventing the current from flowing in the reverse direction is preferably large, and as the diode used in the rectifier circuit 2, the above-described resistance value needs to be larger than 1.43 MΩ, and is preferably 10 MΩ or more. As a result, among the three diodes mentioned as examples, 1N60 (silicon) has the most suitable characteristics.

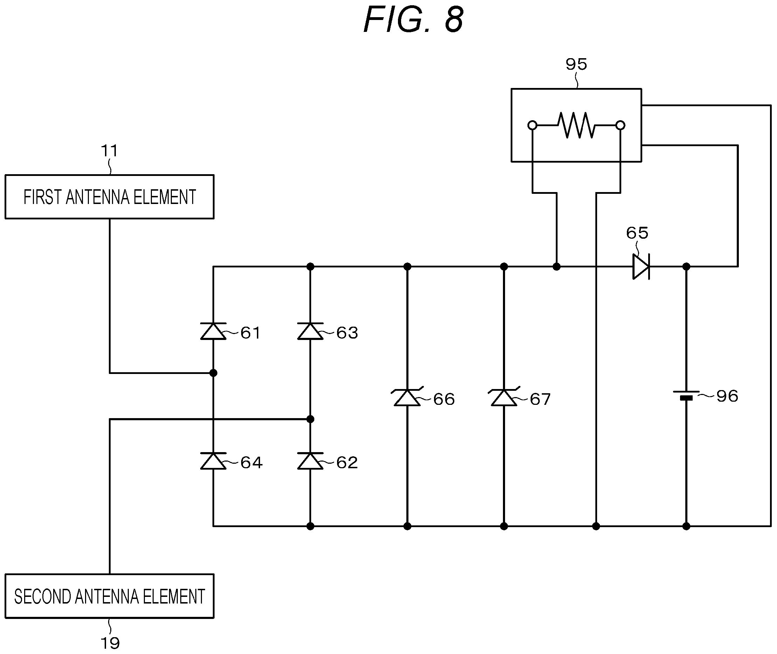

As illustrated in Fig. 8, a full-wave rectifier circuit (including diodes 61 to 64 and Zener diodes 66 and 67) is connected to the antenna device 1, and an output voltage of the full-wave rectifier circuit can be measured by a high-resistance (2 MΩ or higher, desirably 10 MΩ) sensor, for example, a voltmeter 95. Furthermore, a battery 96 is charged via a backflow prevention diode 65 by the output of the full-wave rectifier circuit, and the output of the battery 96 is used as a power supply of the voltmeter 95.

By using a high resistance sensor, it is possible to measure the voltage induced in the metal. Then, by analyzing the acquired data, it is possible to acquire an operating status of a motor of a device, an inverter, and the like. As a result, the state of the device can be grasped, and an alert or the like can be issued before failure.

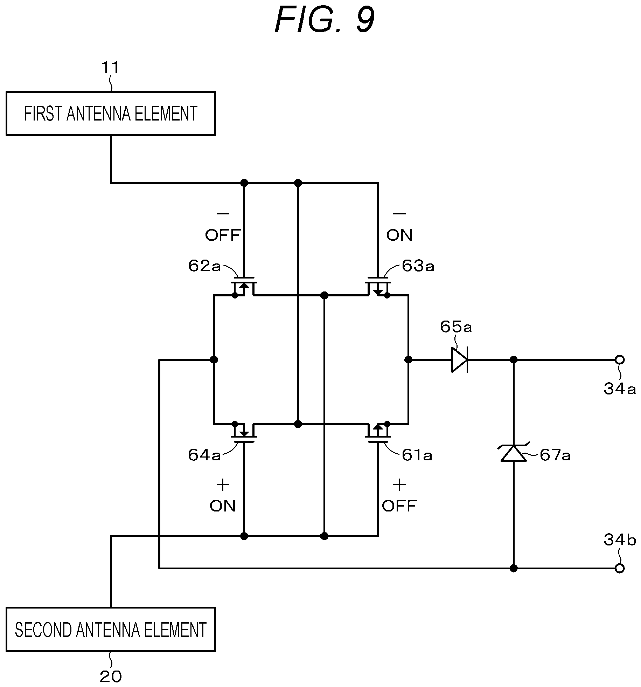

As the rectifier circuit 2 connected to the antenna device 1, in addition to the configuration of the full-wave rectifier circuit using the diode illustrated in Fig. 6, as illustrated in Fig. 9, a rectifier circuit using a metal oxide semiconductor (MOS) field effect transistor (FET) instead of the diode as a switching element can be used. That is, a rectifier circuit includes four FETs 61a, 62a, 63a, and 64a, a backflow prevention diode 65a, and an FET protection Zener diode 67a.

The FETs 61a and 63a are P-channel depletion MOSFETs, and when a negative voltage is applied to a gate, a current flows from a drain to a source. The FETs 62a and 64a are N-channel depletion MOSFETs, and when a positive voltage is applied to a gate, a current flows from a drain to a source.

The drain of the FET 61a and the drain of the FET 64a are connected to each other, and the drain of the FET 62a and the drain of the FET 63a are connected to each other. The gates of the FETs 62a and 63a and a connection point between the drain of the FET 61a and the drain of the FET 64a are connected to the antenna element 11. The gates of the FETs 61a and 64a and a connection point between the drain of the FET 62a and the drain of the FET 63a are connected to the antenna element 20.

As illustrated in Fig. 9, in a phase in which the conductive member 11 side is negative and the antenna element 20 side is positive, the FET 62a is turned off, the FET 63a is turned on, the FET 61a is turned off, and the FET 64a is turned on.

A connection point between the source of the FET 61a and the source of the FET 63a is connected to one output terminal 34a via the backflow prevention diode 65a. A connection point between the source of the FET 62a and the source the FET 64a is connected to the other output terminal 34b. The FET protection Zener diode 67a is connected between the output terminal 34a and the output terminal 34b. Four FETs 61a, 62a, 63a, and 64a may be configured to be discrete or as a dedicated IC.

In the rectifier circuit using the FET, conduction types (N channel/P channel) of the FETs may be switched. The rectifier circuit using the FET can be used instead of the rectifier circuit using the diode described above, and the same effects as those of the embodiment and the modification examples thereof can be obtained. In particular, in a case where the frequency to be harvested is a low frequency of 50 Hz, since the conversion efficiency of the element is better in the FET than in the diode, the FET may be used depending on the device frequency to be harvested.

As described above, the antenna device 1 of the harvester 4 has a dipole structure including two antenna elements. That is, the antenna device 1 includes the first antenna element that is in contact with or connected to the product metal portion or the product metal portion, and the second antenna element that is not in contact with or connected to the product metal portion. The first antenna element is a product metal portion of a car, a refrigerator, a television receiver, a notebook PC, a drone, an ATM, a train, or the like, or an antenna element in contact with or connected to the product metal portion. A second antenna element is an electrode, a copper foil pattern, a coil, or the like formed on a substrate.

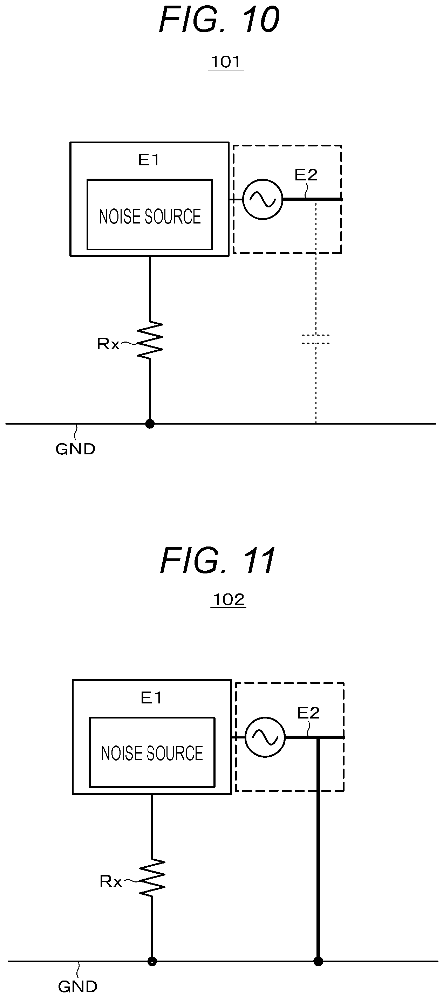

In the present technology, an electric field sensor device is configured by the harvester 4 including the antenna device 1. Figs. 10 and 11 are views schematically illustrating one example and another example of the electric field sensor device. A ground resistor Rx is inserted between a first antenna element E1 (hereinafter, referred to as an antenna element E1) corresponding to the conductive member 11 of the antenna device 1 described above and the ground (earth). The ground resistor Rx is set to a value of 10 kΩ or more as described later.

A second antenna element E2 (hereinafter, simply referred to as an antenna element E2) corresponding to the ground electrode 19, the copper foil pattern, the meander antenna on the substrate, and the like of the antenna device 1 described above is not earthed. The antenna element E2 is capacitively coupled to the ground (earth). An electric field sensor device 101 having the configuration illustrated in Fig. 1 including the antenna device containing the antenna elements E1 and E2 is schematically illustrated as illustrated in Fig. 10. The voltage induced by the antenna element E1 and the antenna element E2 is represented by a voltage source.

An electric field sensor device 102 illustrated in Fig. 11 has a configuration in which the antenna element E2 is connected to the ground. The antenna element E1 may have a noise source or may not have a noise source. The electric field sensor devices 101 and 102 illustrated in Figs. 10 and 11 each have a noise source. The noise source means a source that generates noise having a frequency of several Hz to 1 MHz included in the product metal portion. Such noise is generated from a switching power supply, a motor, and the like. Even in a case where such a noise source does not exist, various electric fields such as a quasi-electrostatic field and an electromagnetic wave are constantly generated in the space, and the output voltage of the harvester is generated by the electric field energy in such a space.

In the electric field sensor device 101 illustrated in Fig. 10, since the antenna element E2 that is not in contact with or connected to the metal portion of the device, which is a conductor, is not earthed, the antenna element E2 can function as a sensor.
Furthermore, the antenna element E1 side can also function as a sensor. That is, one of the antenna element E1 and the antenna element E2 can function as a sensor.

In the electric field sensor device 102, since the antenna element E2 is earthed, the antenna element E2 does not function as a sensor. The antenna element E1 functions as a sensor. Since it is important to increase the potential difference between the antenna element E1 and the antenna element E2 in the arrangement of the antenna elements, it is desirable to arrange the antenna element on the sensor side so as to face the detection target, and arrange the antenna element not on the sensor side so as not to face the detection target. However, in a case where the antenna element that is not on the sensor side is connected to the ground or a member coupled to the ground by a coated cable or the like, the antenna element may be laid close to the detection target, depending on the dielectric constant of the coated cable.

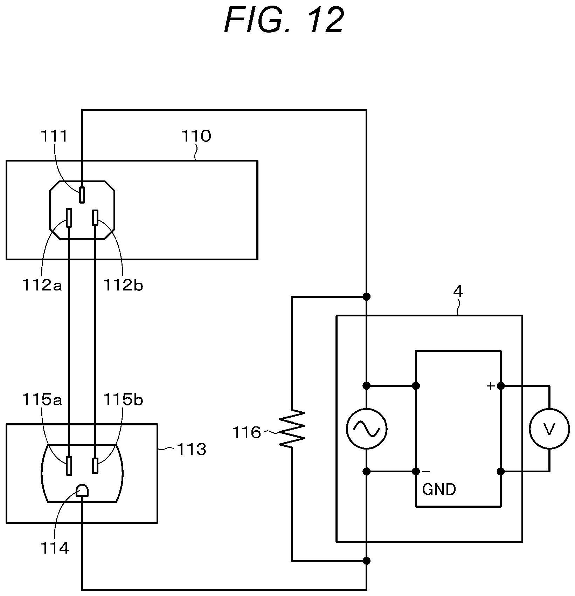

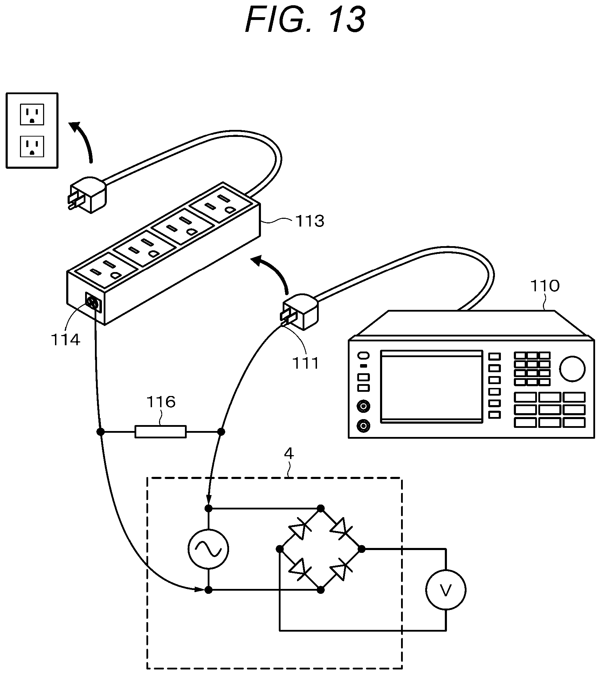

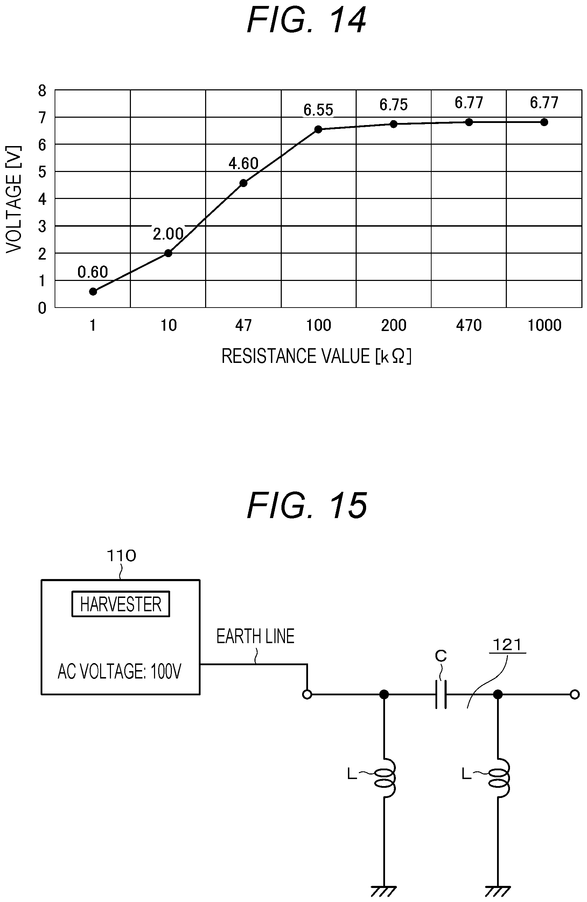

Figs. 12 and 13 are schematic diagrams illustrating a measurement device for measuring a relationship between the output of the harvester 4 and the ground resistor. Fig. 14 is a graph illustrating a relationship between the output of the harvester device and the ground resistor. In the measurement device illustrated in Figs. 12 and 13, the harvester 4 (see Fig. 6) for a test is connected between a ground terminal 111 of a device 110 (here, a measurement device driven at 100 V AC) and a GND 114 provided on the socket of a power tap 113. A resistance element 116 is connected between input terminals of the harvester 4. The harvester 4 has the device 110 as one antenna element E1 and the power tap 113 as the other antenna element E2.

One input terminal of the harvester 4 is connected to the ground terminal 111 of the device 110, and the other input terminal is connected to the GND 114. Note that output terminals 115a and 115b of the power tap 113 are connected to two power supply terminals 112a and 112b provided in the device 110, respectively, and 100 V AC is supplied thereto. The resistance element 116 is connected between the input terminals of the harvester 4. The resistance element 116 is an element such as a wire wound resistor in which a predetermined DC resistance value is set. The resistance element 116 functions as a ground resistor that connects the device 110 and the GND 114. For example, in a case where the resistance element 116 is sufficiently large, the device 110 is substantially in a floating state with respect to the GND 114.

In the measurement device illustrated in Figs. 12 and 13, the output voltage (voltage between the output terminals) of the harvester 4 is measured by changing the DC resistance value of the resistance element 116. The graph illustrated in Fig. 14 illustrates an output voltage [V] detected by the harvester 4 in a case where the DC resistance value [Ω] of the resistance element 116 serving as the ground resistor is changed. For example, in a case where the DC resistance value is 1 kΩ, which is relatively low, the detection voltage is 0.60 V. Furthermore, in a case where the DC resistance value is 10 kΩ, a voltage of 2.00 V is detected, and in a case where the DC resistance value is 47 kΩ, 4.60 V is detected. As described above, the ground of the device 110 serving as an antenna element E1 approaches a floating state with respect to the GND 114, which is the ground of the earth, and the detection voltage is higher as the DC resistance value is higher.

Moreover, when the DC resistance value is increased, for example, the detection voltage becomes 6.55 V at the time point when the DC resistance value is 100 kΩ. This is substantially the same as the value (6.77 V) in a state where the resistance element 116 is removed and the ground of the device 110 is completely floated. That is, by inserting the resistance element 116 having a DC resistance of about 100 kΩ, the antenna element E1 is substantially in a floating state with respect to the ground, and the harvester 4 induces a voltage without any problem. Note that even when the DC resistance is in the range of 100 kΩ or less, for example, if the resistance value is 10 kΩ or more, a voltage of 2.00 V or more can be induced.

In Figs. 12, 13, and 14, the DC resistance component of the ground resistor is described. On the other hand, the electric field energy taken in by the harvester 4 is mainly energy of an AC signal. Therefore, for example, when the resistance (impedance) to the AC signal of the target frequency is sufficiently large, it is possible to cause the ground of the device 110 to be close to a floating state at the frequency, and it is possible to induce a high voltage. Specifically, an inductance of a coil or the like can be used.

For example, in a case of being connected to an AC power supply of 50 Hz (or 60 Hz), an AC signal of 50 Hz (or 60 Hz) is considered to be a main source of the electric field energy. Therefore, for example, in a case where the impedance at 50 Hz (or 60 Hz) is 10 kΩ or more, the ground of the device 90 is substantially in a floating state as described above, and the energy can be efficiently taken in.

However, depending on the device 110 connected to the harvester 4, in order to prevent electric shock to the human body, grounding to the earth ground may be defined as a measure against electric leakage according to safety standards. In this case, all the energies induced in the device 110 escapes to the ground, and no voltage is induced.

Referring to the current safety standards in Japan, an example of the device to which the harvester 4 is applied includes a device for which a D-class grounding work (hereinafter, referred to as D grounding) is required. The D grounding is a grounding work performed on a low-voltage mechanical tool using 300 V or less, a metal outer box, and a metal pipe. For example, D grounding is performed for a device that needs to be grounded among devices used by being connected to a 100 V AC power supply. As an example, the earth ground of the devices such as a microwave oven, a refrigerator, a washing machine, a laundry dryer, an air conditioner, a dehumidifier, various measurement devices, a factory robot, and a server device conforms to this standard. As described above, in a case where a general device is used, the D grounding is used as a reference.

Hereinafter, it is assumed that the D grounding is performed for a device to which the harvester 4 is applied.

In the D grounding, a ground resistor in which a DC resistance is 100 Ω or less is required. Note that in a case where a device that automatically cuts off the electric path within 0.5 seconds in a case where a ground fault (electric leakage) occurs is provided in the low-voltage electric path, a ground resistor having a DC resistance of 500 Ω or less may be used. For example, in a case where there is a mechanism for cutting off power supplied to the device when a dark current is detected, the ground resistor may be changed from 100 Ω to 500 Ω in the D grounding.

In order to solve this problem and induce the electric field energy in the harvester 4, it is desirable to realize a low resistance value that indicates a high impedance at the frequency of the AC signal induced in the device 110 and satisfies the safety standards in the direct current. In the case of harvesting the electric field energy of 100 MHz or more which is a high frequency to some extent, it is possible to separate the frequency of the direct current and the frequency of the AC signal to be harvested from each other by using the inductance of only the coil inserted between the earth line and the harvester 4, and to configure high impedance (100 kΩ or more) at the frequency of the AC signal to be harvested.

However, in a case of being connected to the low AC power supply of 50 Hz (or 60 Hz), the AC signal of 50 Hz (or 60 Hz) may be considered to be a main source of the electric field energy. In such a case, the inductance of only the coil has a very large value, and it is difficult to create a floating state in the space only by using the coil. That is, the inductance value is several 100 H, which is not realistic.

In order to realize a state where the device 110 floats with such an AC signal of 50 Hz (or 60 Hz), a high-pass filter structure 121 (Chebyshev high-pass filter) as illustrated in Fig. 15 is considered. The output terminal of the high-pass filter 121 is open. Since the coil is included in the preceding stage of the filter, a high impedance (100 kΩ or more) can be realized in the AC signal of 50 Hz (or 60 Hz) by setting the DC resistance value of the coil of this portion so as to satisfy the safety standards. Thus, the inductance of the coil can be reduced even at a low frequency, and miniaturization can be realized. For example, in a case where this filter is configured at 50 Hz, the inductance of the coil is 22 mH, the capacitance of the capacitor is 470 µF, and the DC resistance of the coil is 22 Ω.

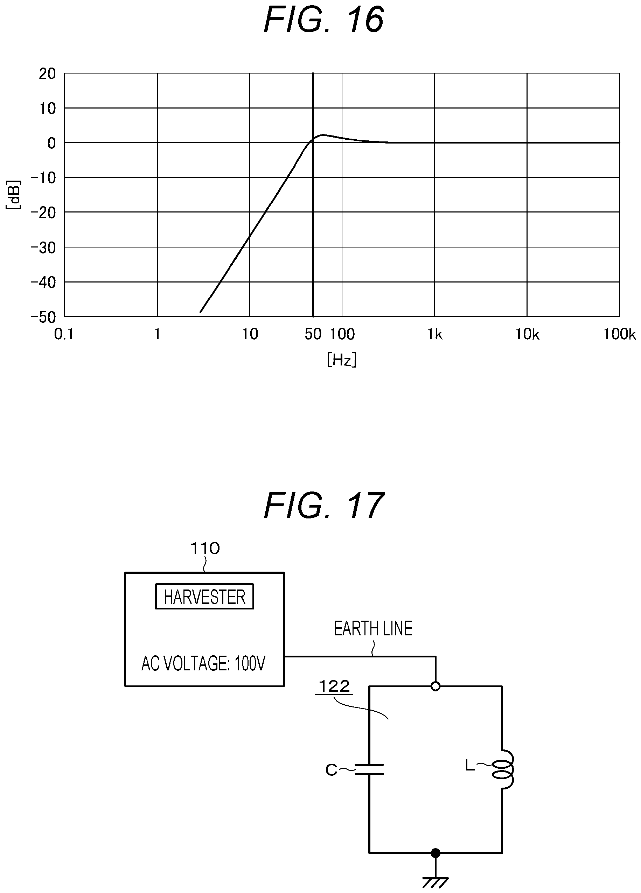

The frequency characteristics of the high-pass filter 121 are as illustrated in Fig. 16. The capacitance of the capacitor has a frequency component, and decreases at a frequency of 1 kHz or more even when the capacitance shows a high value at 50 Hz (or 60 Hz). Thus, in a case where more frequency components are induced in the device 110 as electric field energy, when it is desired to harvest the energy, it cannot be harvested only by the high-pass filter structure 121.

In order to solve such a problem, as illustrated in Fig. 17, a frequency component of the electric field energy induced in the device 110 is measured in advance, and a parallel resonance circuit 122 having a high impedance with the ground at the frequency can be configured between the earth line and the ground.

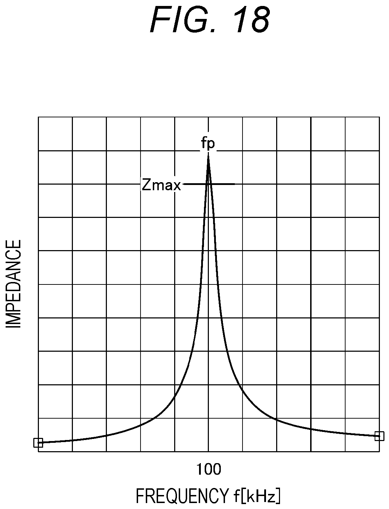

Since the parallel resonance circuit 122 has a configuration in which a coil and a capacitor are inserted in parallel, the parallel resonance circuit 122 has a high impedance at the frequency of the electric field energy induced in the device 110 and desired to be harvested, and has the DC resistance of the coil in the direct current. Therefore, the parallel resonance circuit 122 can be configured so as to satisfy the safety standards. For example, as illustrated in Fig. 18, in a case where the parallel resonance circuit 122 having characteristics that the impedance is maximized at 100 kHz is configured, the DC resistance of the coil is 0.04 Ω with the inductance of the coil of 10 mH and the capacitance of the capacitor of 0.5 µF. The parallel resonance circuit 122 desirably includes an electrolytic capacitor since the frequency range in which the impedance is high is widened as a Q value is higher.

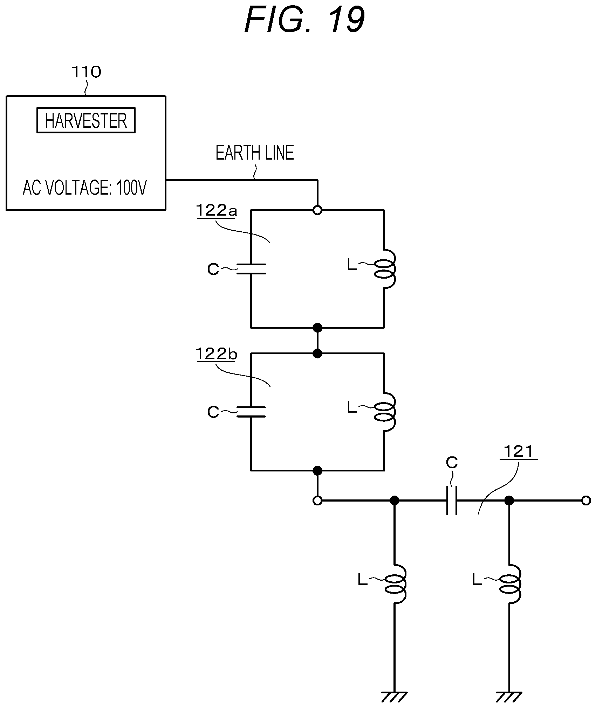

By combining the high-pass filter 121 and the parallel resonance circuit 122 (at least one or more), it is possible to take in electric field energy in accordance with various frequency components induced in the device 110 while satisfying the safety standards for performing the D grounding of the device 110 with the earth line. The high-pass filter 121 and the parallel resonance circuit 122 may be used alone in accordance with the frequency component of the electric field energy generated in the device 110, or may be used in combination as appropriate in accordance with the frequency to be harvested so as to satisfy the resistance value in the safety standards. Fig. 19 illustrates an example in which parallel resonance circuits 122a and 122b and the high-pass filter 121 are combined.

Although the filter causing the device 110 to be in a floating state in accordance with the frequency to be harvested has been described so far, the first antenna element of the harvester 4 can be connected to the output terminal (open) of the high-pass filter 121 of the filter in the middle of the earth ground, and the second antenna element can be configured by the earth ground or an antenna such as a meander line of copper foil on a substrate. For example, in the case of a three-terminal outlet having a GND line in a factory, since the GND line can be configured in a portion connected to the outlet of the device 110, the GND line can be easily configured for each device 110, and the state of each device 110 can be managed.

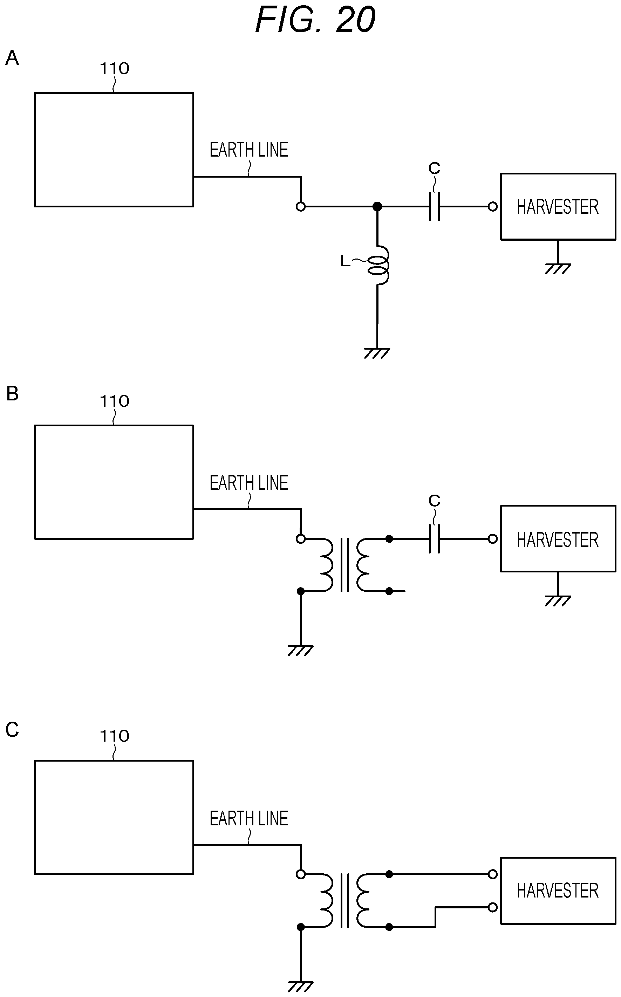

Although the filter causing the device 110 to be in a floating state in accordance with the frequency to be harvested has been described so far, the first antenna element of the harvester can be connected to the output terminal (open) of the high-pass filter of the filter in the middle of the earth ground, and the second antenna element can be configured by the earth ground (see Fig. 20A) or an antenna such as a meander line of copper foil on a substrate. For example, in the case of a three-terminal outlet illustrated in Fig. 13 in which there is a GND line in a factory, since the harvester can be configured in a plug portion of the device 110, it is possible to harvest energy from the entire device 110 by using the GND of the device 110 as an antenna element.

In the configuration of Fig. 20A, the high-pass filter is connected, but a transformer may be connected as illustrated in Fig. 20B or 20C. Since the harvester and the device 110 are completely separated from each other by the transformer, it is possible to prevent a large amount of current from flowing through the harvester at the time of electric leakage, and it is possible to enhance the safety. In this example, the configuration using the high-pass filter and the transformer has been described, but the configuration can be replaced with the parallel resonance circuit and the electric leakage filter such as the inductor, which have been described above.

A device that does not need to be grounded to the earth ground by connecting a commercial AC power supply, for example, a product such as a television, a hard disk recorder, a game device, or an audio device, is a device floating from the ground. Furthermore, a drone and a vehicle are used with an earth ground and a certain resistance. In order to efficiently harvest power by using these devices, for example, it is necessary to separate GND of a power supply board using an inverter circuit that generates large power and other metal portions of the device. From the above-described experimental results, it can be seen that when the resistance value for separation is 10 kΩ or more, an antenna element 1 and an antenna element 2 can be separated to harvest power.

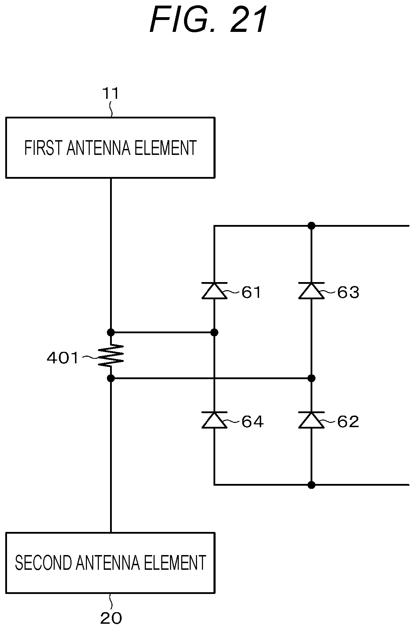

That is, as illustrated in Fig. 21, when the GND of the power supply board using the inverter circuit that generates large power is set as a first antenna element 11 and the other metal portion of the device is set as a second antenna element 20, the power can be harvested from the harvester by inserting and separating a resistor 401 of 10 kΩ or more between the antenna elements. By separating in advance inside the device in this manner, it is possible to harvest a large amount of power as compared with an arrangement in which the harvester is placed outside and the harvester and the device are connected and used.

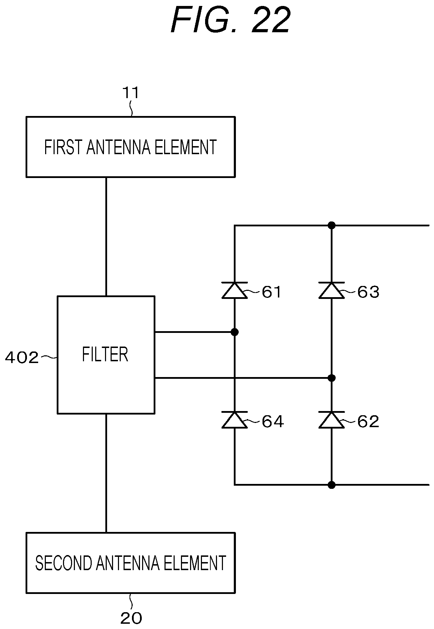

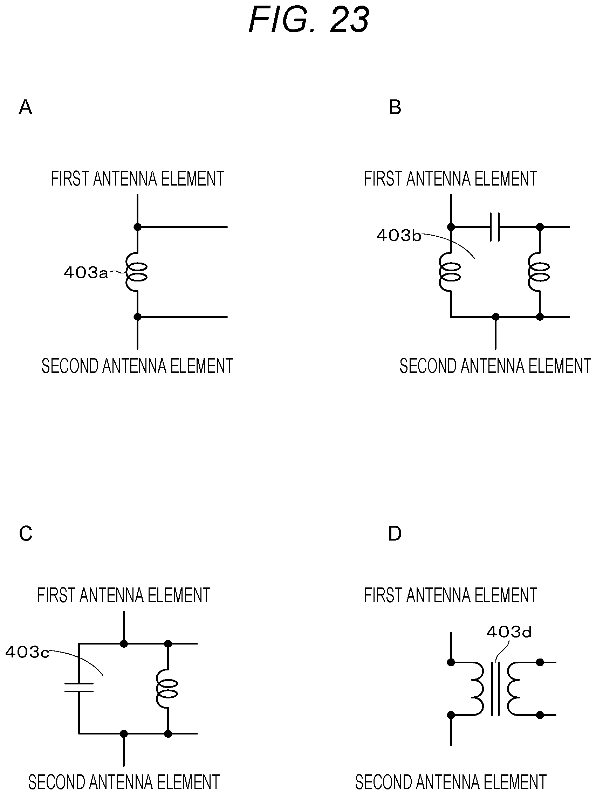

Moreover, as illustrated in Fig. 22, by connecting a filter 402 instead of the separation resistor, a significantly low resistance can be realized in the direct current, and the resistance value can be increased according to the frequency of the power to be harvested. Specific examples of the filter 402 include an inductor 403a (Fig. 23A), a high-pass filter 403b (Fig. 23B), a parallel resonance circuit 403c (Fig. 23C), and a transformer 403d (Fig. 23D) in accordance with the frequency of the power to be harvested. By connecting the filter 402, a significantly low resistance can be realized in the direct current, and the resistance value can be increased according to the frequency of the power to be harvested. In particular, in a case where the transformer 403d is used, it is completely separated from the device in terms of a direct current, and thus it is safe to use the harvester.

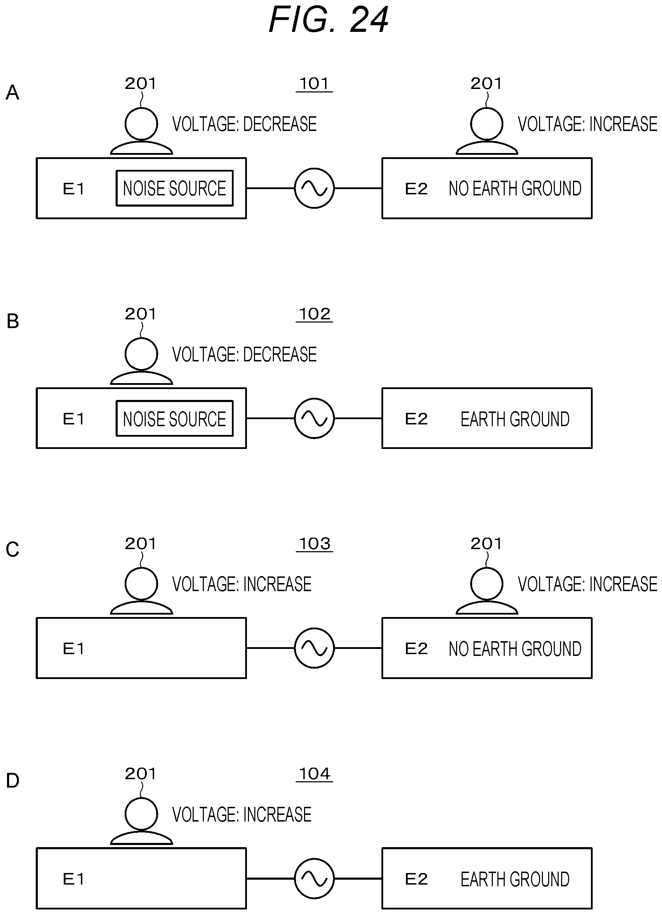

Figs. 24A, 24B, 24C, and 24D illustrate configuration examples of the electric field sensor device according to the present technology. That is, there are configuration examples of the electric field sensor device 101 (Fig. 10, Fig. 24A) in which the antenna element E1 has a noise source and the antenna element E2 is not grounded to the earth ground, the electric field sensor device 102 (Fig. 11, Fig. 24B) in which the antenna element E1 has a noise source and the antenna element E2 is grounded to the earth ground, an electric field sensor device 103 (Fig. 24C) in which the antenna element E1 has no noise source and the antenna element E2 is not grounded to the earth ground, and an electric field sensor device 104 (Fig. 24D) in which the antenna element E1 has no noise source and the antenna element E2 is grounded.

Hereinafter, each electric field sensor device will be described assuming a person or a conductor such as a car or a bicycle as a detection target.

In the electric field sensor device 101 (Fig. 10, Fig. 24A), since the antenna element E2 that is not in contact with or connected to the metal portion of the device, which is a conductor, is not grounded to the earth ground, in a case where a person 201 or a conductor such as a large metal approaches the antenna element E2 side, the metal portion of the device on the antenna element E2 side and the conductor such as the person 201 or the metal are spatially coupled. As a result, the antenna size increases, and more energy of the electric field in the space can be taken in. In this case, the voltage induced in the electric field sensor device 101 increases, and the antenna element E2 side functions as a sensor by observing the increase in voltage.

Since the antenna element E1 has a noise source, the noise source accounts for a large proportion of the voltage induced in the antenna element E1 and the antenna element E2, and in a case where the person 201 approaches, the noise induced in the antenna element E1 is dispersed in the person 201. As the noise level decreases, the voltage induced in the electric field sensor device 101 decreases. Therefore, the antenna element E1 side functions as a sensor by observing the decrease in voltage. In the electric field sensor device 101, one of the antenna element E1 and the antenna element E2 can function as a sensor.

In the electric field sensor device 102 (Fig. 11, Fig. 24B), since the antenna element E2 that is not in contact with or not connected to the metal portion of the device, which is a conductor, is grounded the earth ground, the voltage does not increase (does not change) even if the person 201 approaches the antenna element E2. Therefore, the antenna element E2 does not function as a sensor.

Since the antenna element E1 has a noise source, similarly to the electric field sensor device 101, in a case where the person 201 approaches the antenna element E2, the noise generated from the device is spatially coupled to the approaching person 201, the noise induced in the antenna element E1 is dispersed, and the noise level decreases, so that the induced voltage decreases. In the electric field sensor device 102, the antenna element E1 functions as a sensor.

In the electric field sensor device 103 (Fig. 24C), since the antenna element E2 that is not in contact with or not connected to the metal portion of the device, which is a conductor, is not grounded to the earth ground, in a case where the person 201 or a conductor such as a large metal approaches the antenna element E2 side, the person or the metal is spatially coupled to the metal portion of the device on the antenna element E2 side, the antenna size increases, and more energy of the electric field in the space can be taken in. In this case, the voltage induced in the electric field sensor device 103 increases, and the antenna element E2 functions as a sensor.

Since the antenna element E1 has no noise source, in a case where the person 201 approaches the antenna element E1 side, the person is spatially coupled to the metal portion of the device on the antenna element E1 side, the antenna size increases, and more energy of the electric field in the space can be taken in. In this case, the voltage induced in the electric field sensor device 103 increases. In the electric field sensor device 103, one of the antenna element E1 and the antenna element E2 can function as a sensor.

In the electric field sensor device 104 (Fig. 24D), since the antenna element E2 that is not in contact with or not connected to the metal portion of the device, which is a conductor, is grounded to the earth ground, the voltage does not increase (does not change) even if the person 201 approaches the antenna element E2. Therefore, the antenna element E2 does not function as a sensor.

Since the antenna element E1 has no noise source, in a case where the person 201 approaches the antenna element E1 side, the person is spatially coupled to the metal portion of the device on the antenna element E1 side, the antenna size increases, and more energy of the electric field in the space can be taken in. In this case, the voltage induced in the electric field sensor device 104 increases. In the electric field sensor device 104, the antenna element E2 functions as a sensor.

As described above, as the electric field sensor device, in a case where there is a noise source in the antenna element E1 and a relatively large voltage is induced, it is possible to detect a conductor such as metal or the person 201 by lowering the voltage. On the other hand, in a case where there is no noise source in the antenna element E1, it is possible to detect a conductor such as metal or the person 201 by increasing the voltage. In particular, in the case of using the antenna element as the electric field sensor device while harvesting the energy of noise of the product metal portion, the configuration of the electric field sensor device 101 is preferable, and it is possible to perform detection while increasing the entire voltage by using the antenna element E2 side as the sensor. Note that the detection unit 5 (see Fig. 1) determines whether the voltage rises or falls.

Hereinafter, a plurality of embodiments using any type of the electric field sensor device described above will be described.

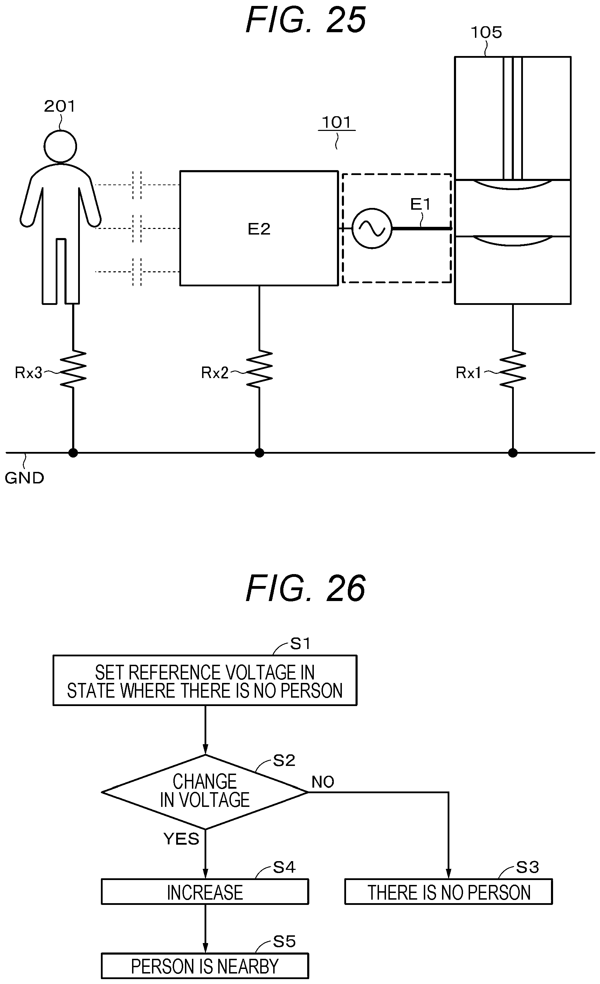

The embodiment illustrated in Fig. 25 is a human sensor by the electric field sensor device 101. The antenna element E2 has a ground resistor Rx2 between the antenna element E2 and the ground. As described above, the ground resistor Rx2 has a value of 10 kΩ or more, and it is possible to obtain a sufficient output from the harvester.

The antenna element E1 is a product metal portion, for example, a cabinet of an electric refrigerator 105. The electric refrigerator 105 is connected to the ground via a ground resistor Rx1. The electric refrigerator 105 includes a noise source.

The antenna element E2 side is set as a sensor. In a case where the person 201 approaches the antenna element E2 side, the antenna element E2 and the person 201 are coupled by capacitance, the antenna size increases, and more energy of the electric field in the space is taken in. The capacity of the coupling depends on the frequency desired to be received. Furthermore, as the distance between the antenna element E2 and the person becomes shorter, the coupling also becomes stronger. As a result, the voltage induced in the electric field sensor device 101 increases. Furthermore, if a product metal portion different from the electric refrigerator is used as the antenna element E2 to be coupled to the person 201, the antenna element E2 can have a relatively large size, so that a capacity with a person approaching the antenna element E2 increases, which is advantageous in that sensor sensitivity is improved.

Fig. 26 is a flowchart illustrating a flow of processing of the detection unit of the electric field sensor device 101 in the embodiment illustrated in Fig. 25.

Step S1: A voltage in a state where no person 201 is present is preset as a reference voltage. By storing the set reference voltage in the storage unit, it is not necessary to repeat the setting of the reference voltage.

Step S2: In the human detection operation, a change in voltage is determined.

Step S3: In a case where it is determined that there is no change in voltage, it is determined that the person 201 is not present.

Step S4: It is determined that the change in voltage is an increase.

Step S5: In a case where the change in voltage is an increase, it is determined that the person 201 is nearby. Moreover, the determination result is transmitted to the control side by the communication unit. A threshold may be set for the change in voltage. Moreover, the distance from the sensor to the person 201 may be determined by the value of the voltage.

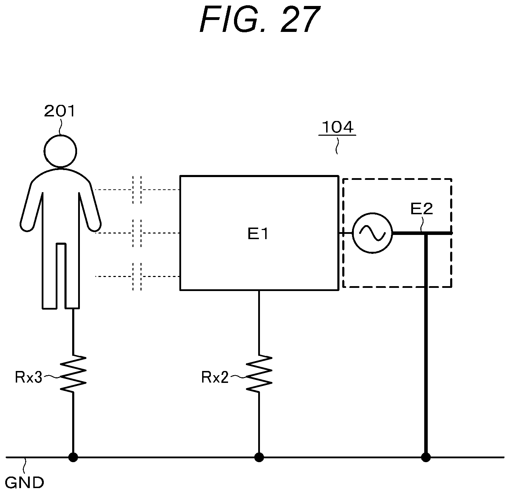

The embodiment illustrated in Fig. 27 is another example of a human sensor using the electric field sensor device 104. That is, the antenna element E1 has no noise source, and the antenna element E2 is grounded to the earth ground. When the person 201 approaches the antenna element E1, the antenna element E1 and the person 201 are coupled by capacitance. Therefore, the voltage increases as the person 201 approaches. Moreover, the distance to the person 201 can be determined from the value of the voltage.

Although not illustrated, in the configuration of Fig. 27, in a case where there is a noise source in the antenna element E1, the electric field sensor device 102 is configured. In the electric field sensor device 102, when a person approaches the antenna element E1, noise energy is dispersed to the person, so that the voltage decreases. Therefore, the approach of a person can be detected by detecting a decrease in voltage. Moreover, the distance to a person can be determined from the value of the voltage.

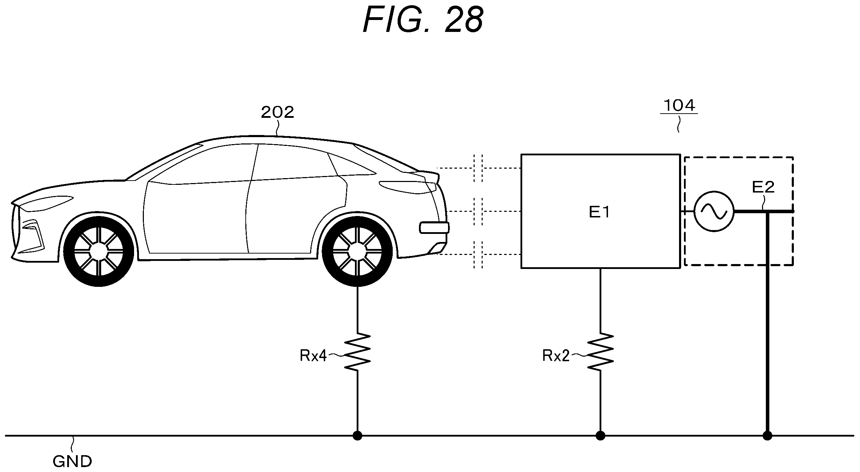

The present technology can be applied not only to detection of a person but also to detection of a metal conductor. For example, an embodiment in which the present technology is applied to detection of a car is illustrated in Fig. 28. A car 202 has a ground resistor Rx4 of 10 kΩ or more. The antenna element E1 (without a noise source) and the antenna element E2 (grounded to the earth ground) constitute the electric field sensor device 104. The antenna element E1 is used as a sensor.

When the car 202 approaches the antenna element E1, the antenna element E1 and the car 202 are coupled by capacitance, the antenna size increases, and more energy of the electric field in the space is taken in. As the distance between the antenna element E1 and the car 202 becomes shorter, the coupling also becomes stronger. As a result, the voltage induced in the electric field sensor device 104 increases. Furthermore, since the antenna element E1, which is an antenna to be coupled, can have a relatively large size (all the metal portions of the device) in order to use a product metal portion, for example, a gate of an entrance of a parking lot, a shutter gate, and the like as an antenna, the size is larger than that of another antenna and the capacity with the approaching car 202 is increased, so that the antenna element E1 has an advantage that the sensor sensitivity is improved.

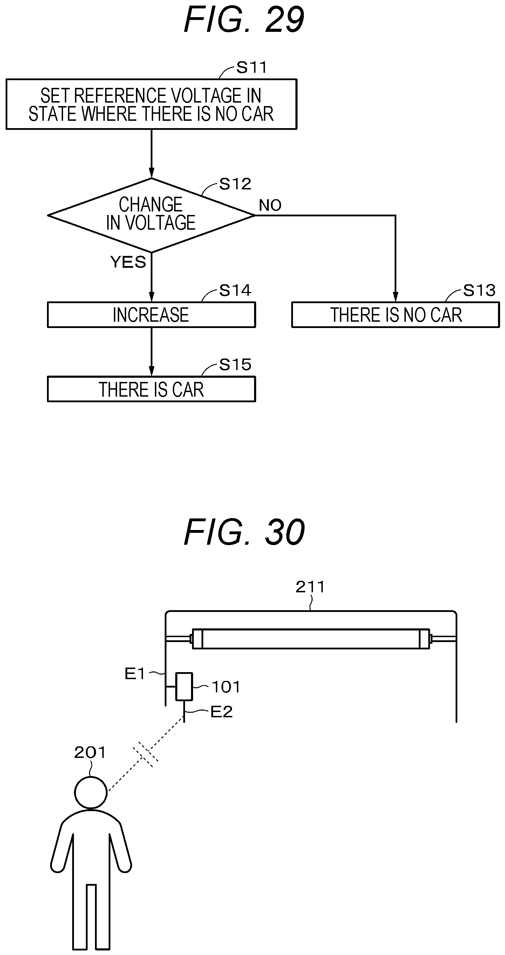

Fig. 29 is a flowchart illustrating a flow of processing of the detection unit of the electric field sensor device 104.

Step S11: A voltage in a state where there is no car 202 is preset as a reference voltage. By storing the set reference voltage in the storage unit, it is not necessary to repeat the setting of the reference voltage.

Step S12: Then, when the car inspection operation is started, a change in voltage is determined.

Step S13: In a case where it is determined that there is no change in voltage, it is determined that there is no car 202.

Step S14: It is determined that the change in voltage is increased.

Step S15: In a case where the voltage change is increased, it is determined that the car 202 is nearby. Moreover, the determination result is transmitted to the control side by the communication unit. According to this determination result, for example, control is performed such that the gate of the parking lot is opened. A threshold for a change in voltage may be set. Moreover, the distance to the car 202 may be determined by the value of the voltage.

Note that, in a case where there is a noise source in the antenna element E1, the electric field sensor device 102 is configured. In this configuration, when the car 202 approaches the antenna element E1, noise energy is dispersed in the car 202, so that the voltage decreases. Therefore, the approach of the car 202 can be detected by detecting the decrease in voltage. Moreover, the distance to the car 202 can be determined from the value of the voltage.

Fig. 30 schematically illustrates an example in which the electric field sensor device 101 is provided in association with a lighting device such as a fluorescent lamp device 211 installed in a room such as a conference room, a car, or the like. In the case of the fluorescent lamp device 211, the inverter turns on the fluorescent lamp by once changing a commercial power supply of 50 Hz or 60 Hz to a direct current and further changing to a high-frequency signal of 20 to 50 kHz. In this lighting method, there is no flicker peculiar to a fluorescent lamp as compared with lighting at a frequency of a commercial power supply.

A large noise is generated from a commercial power supply in order to perform switching and frequency conversion. By bringing the metal portion of such a fluorescent lamp device 211 into contact with the antenna element E1, the fluorescent lamp device can be configured as an antenna element, and can be used as a sensor while harvesting energy to increase the overall voltage. As a configuration in this case, the configuration of the electric field sensor device 101 is suitable. The antenna element E2 is not grounded to the earth ground. The antenna element E2 is used as a sensor of the person 201.

When the person 201 enters the room, the distance between the antenna element E2 and the person 201 decreases, the antenna element E2 and the person 201 are coupled by capacitance, the antenna size increases, and more energy of the electric field in the space is taken in. As the distance between the antenna element E2 and the person becomes shorter, the coupling also becomes stronger. As a result, the voltage induced in the electric field sensor device 101 increases.

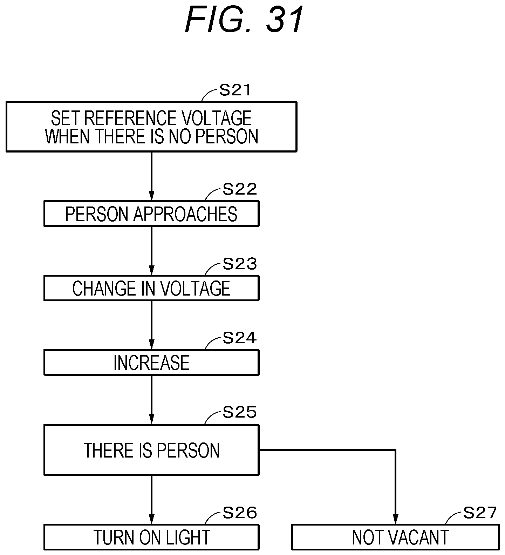

Fig. 31 is a flowchart illustrating a flow of processing of the detection unit of the electric field sensor device 101.

Step S21: The voltage when the person 201 is not present is preset as the reference voltage. By storing the set reference voltage in the storage unit, it is not necessary to repeat the setting of the reference voltage.

Step S22: Then, the person 201 approaches.

Step S23: The voltage changes.

Step S24: It is determined that the change in voltage is increased.

Step S25: In this case, it is determined that the person 201 is in the room.

Step S26: Moreover, the determination result is transmitted to the communication unit or directly to the control circuit of the fluorescent lamp device 211, and the fluorescent lamp device 211 is automatically turned on.

Step S27: Furthermore, the determination result is transmitted to a vacant management system on the cloud by communication, and it is notified that the conference room is in use.

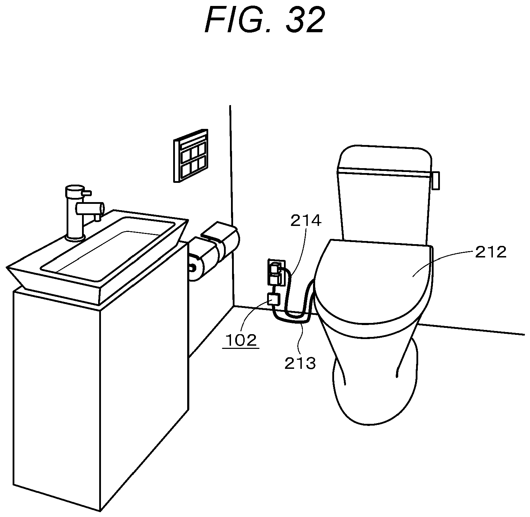

An embodiment in which the present technology is applied to a warm-water cleaning toilet seat 212 will be described with reference to Fig. 32. An earth line 213 and a power supply line 214 are wired between the warm-water cleaning toilet seat 212 and the power outlet. By bringing the metal portion of the warm-water cleaning toilet seat 212 into contact with the antenna element E1, the fluorescent lamp device can be configured as an antenna element, and can be used as a sensor while harvesting energy to increase the overall voltage. The electric field sensor device 102 (including an electrode as the antenna element E2) is inserted into a middle of the earth line 213 of the warm-water cleaning toilet seat 212. Since the warm-water cleaning toilet seat 212 has a noise source, when a person approaches the warm-water cleaning toilet seat 212, the voltage of the electric field sensor device 102 decreases, and the approach of the person can be detected.

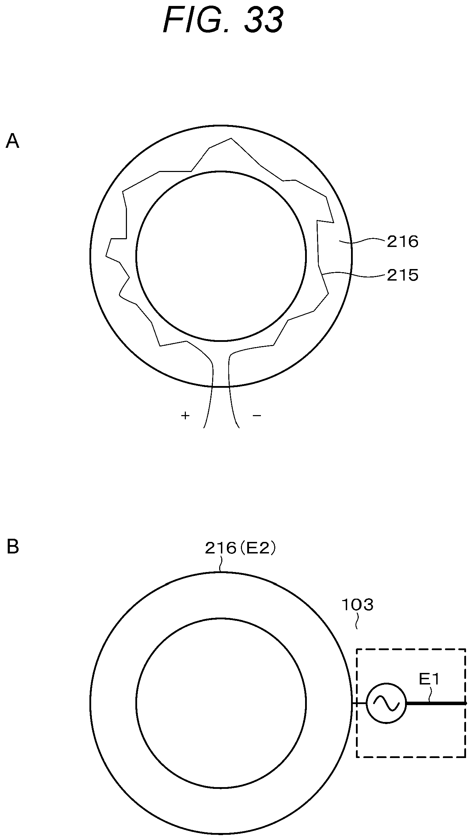

Another embodiment related to the warm-water cleaning toilet seat will be described with reference to Figs. 33A and 33B. As schematically illustrated in Fig. 33A, a heater 215 and an aluminum foil (schematically shown as a ring-shaped portion) 216 are housed in a resin toilet seat of the warm-water cleaning toilet seat, and the toilet seat is warmed by heating the aluminum foil 216 by the heater 215. The aluminum foil 216 floats with respect to the earth ground.

Therefore, as illustrated in Fig. 33B, the electric field sensor device 103 is configured by using the aluminum foil 216 as the antenna element E2 and bringing the metal portion of the warm-water cleaning toilet seat 212 into contact with the antenna element E1. When a person approaches the toilet seat, the antenna element E2 and the person are coupled by capacitance, the antenna size increases, and more energy of the electric field in the space is taken in. As the distance between the antenna element E2 and the person becomes shorter, the coupling also becomes stronger. As a result, the voltage induced in the electric field sensor device 103 increases.

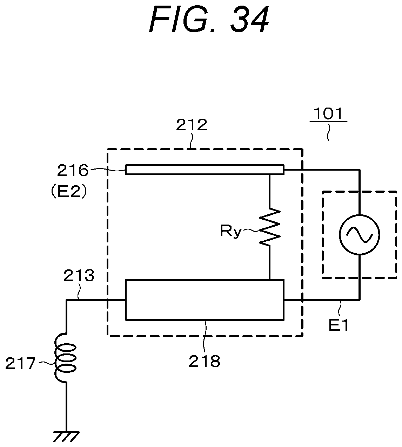

Fig. 34 schematically illustrates still another embodiment in which the present technology is applied to the warm-water cleaning toilet seat. A coil 217 is inserted to create a spatially floating state at a frequency requiring the warm-water cleaning toilet seat between earth line 213 of the warm-water cleaning toilet seat and the ground, that is, to increase impedance in a required frequency band. Accordingly, a circuit unit 218 such as a power source of the warm-water cleaning toilet seat 212 floats with respect to the ground.

A metal portion of the warm-water cleaning toilet seat 212 is brought into contact with the antenna element E1. The aluminum foil 216 of the toilet seat of the warm-water cleaning toilet seat 212 serves as the antenna element E2. Therefore, when the electric field sensor device 101 is configured and a person approaches the toilet seat (antenna element E2), the voltage of the electric field sensor device 101 increases. Note that a separation resistor Ry of 10 kΩ or more is inserted between the antenna elements E1 and E2 to separate the two antenna elements, including electrostatic countermeasures and the like. With the configuration in which the portion in contact with the human body is separated from the circuit unit 218, it is possible to prevent an electric shock or the like at the time of electric leakage.

Note that in a case where all the conductors of the warm-water cleaning toilet seat as the product metal portion are used as one antenna, it is necessary to increase the size of the other antenna coupled to the ground in order to take in larger energy. On the other hand, by dividing the conductor of the warm-water cleaning toilet seat into two by the separation resistor Ry, the antenna element coupled to the ground can be increased, and the harvestable energy can be increased.

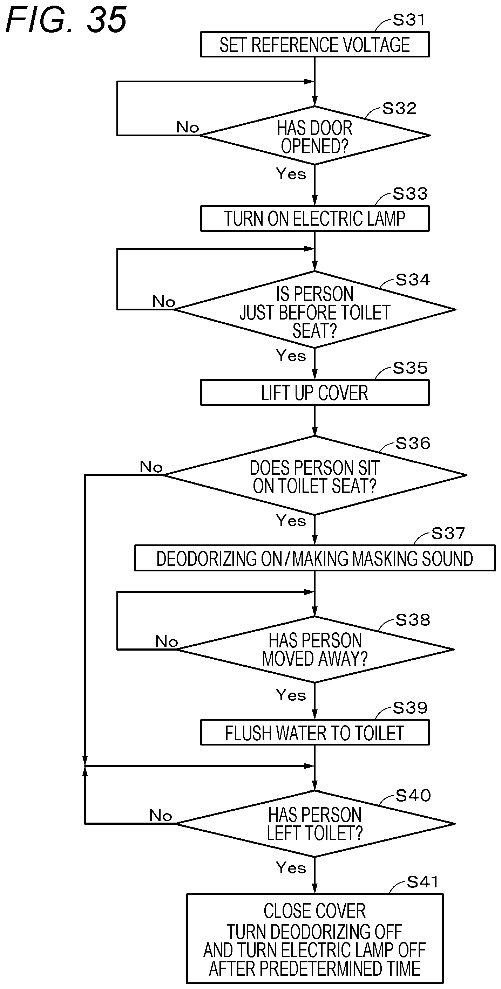

The operation of the configuration of Fig. 34 will be described with reference to the flowchart of Fig. 35.

Step S31: A reference voltage is set. That is, the voltage of the electric field sensor device 101 in a state where an electric light is turned off in the toilet and there is no person is set as the reference voltage. By storing the set reference voltage in the storage unit, it is not necessary to repeat the setting of the reference voltage.

Step S32: Whether a person approaches and opens the door of the toilet is determined from the voltage change. When a person approaches and opens the door, the voltage of the electric field sensor device 101 increases with respect to the reference voltage.

Step S33: When it is determined that a person approaches and opens the door of the toilet, a determination result is transmitted to the lighting device, and the electric light in the toilet is turned on.

Step S34: It is determined whether a person comes just before the toilet seat. When a person comes just before the toilet seat, the voltage of the electric field sensor device 101 further increases. A further increase in this voltage is detected. The determination result is transmitted to the control unit of the warm-water cleaning toilet seat.

Step S35: When it is determined that a person comes just before the toilet seat, the cover of the toilet seat is turned up by the control unit.

Step S36: It is determined whether a person sits on the toilet seat. It is detected that a person sits on the toilet seat from the further increase in voltage of the electric field sensor device 101. When it is determined that a person has sat on the toilet seat, a determination result is transmitted to the control unit of the warm-water cleaning toilet seat.

Step S37: When it is determined in step S36 that a person has sat on the toilet seat, the determination result is transmitted to the control unit of the warm-water cleaning toilet seat, a deodorizing device is turned on by the control unit, and a masking sound (for example, water stream sound) for masking a sound during excretion is generated.

Step S38: It is determined whether a person has moved away from the toilet seat. The separation of the person from the toilet seat is detected from the decrease in voltage of the electric field sensor device 101. When it is determined that the person has moved away from the toilet seat, the determination result is transmitted to the control unit of the warm-water cleaning toilet seat.

Step S39: When it is determined in step S38 that a person has moved away from the toilet seat, water is flushed into the toilet bowl.

Step S40: It is determined whether a person has left the toilet. From the further decrease in voltage of the electric field sensor device 101, it is detected that a person has left the toilet. When it is determined that a person has left the toilet, a determination result is transmitted to the control unit of the warm-water cleaning toilet seat.

Step S41: When it is determined in step S40 that a person has left the toilet, the cover falls down to be closed. Deodorization is turned off and the electric light of the toilet is turned off a predetermined time after the cover is closed.

In the above-described warm-water cleaning toilet seat, in a case where a person sits on the toilet seat, the person directly touches the toilet seat, so that a voltage corresponding to an individual can be measured. The health condition may be determined by measuring the voltage every day. Furthermore, it can be used like a body fat meter by measuring the voltage. Moreover, a change in voltage of a way of walking (way of approaching) unique to an individual at the time of entering the toilet may be registered in advance, an individual may be identified from the change in voltage of the way of walking, and health management may be performed by transmitting health condition data to a smartphone or the like of the individual.

Moreover, by attaching an electric field sensor device to a lighting device such as a fluorescent lamp or a light emitting diode and using a metal portion of the lighting device as an antenna, lighting of the lighting device may be controlled separately from the electric field sensor device attached to the warm-water cleaning toilet seat.

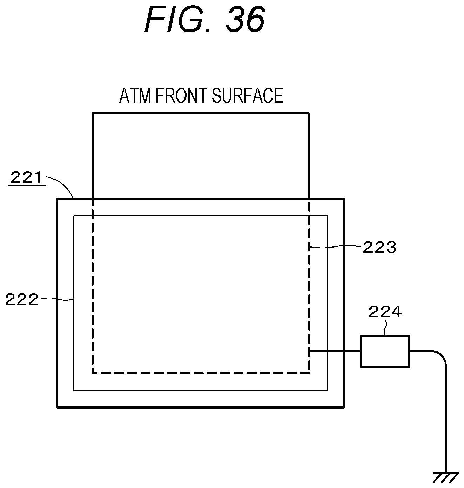

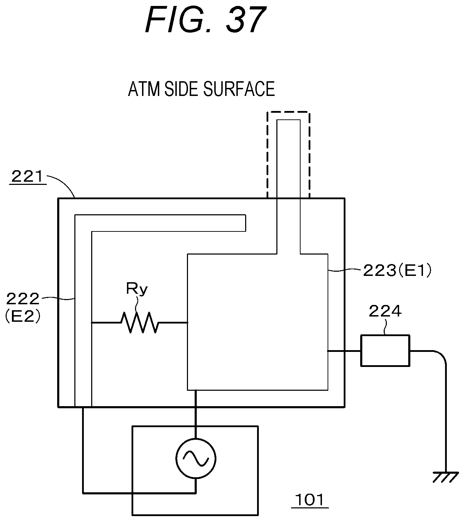

Next, an embodiment in which the present technology is applied to an ATM will be described with reference to Figs. 36, 37, and 38. Fig. 36 schematically illustrates a front surface of an ATM 221, and Fig. 37 schematically illustrates a side surface of the ATM 221.

A metal frame 222 having an L-shaped cross section is provided to cover a part of the front surface and the upper surface of the ATM 221. An ATM main body 223 is provided inside the ATM 221. The ATM main body 223 includes a touch panel, a power supply circuit, a printer unit, a banknote, a coin receiving and dispensing mechanism, and the like.

A separation resistor Ry of 10 kQ or more is connected between the metal frame 222 and the ATM main body 223. By separating the metal frame 222 in contact with the human body from the ATM main body 223, electric shock or the like at the time of electric leakage can be prevented. Moreover, the ATM main body 223 is grounded via a coil 224. The ATM main body 223 has a noise source, and the metal frame 222 does not have a noise source. In the frequency band of the noise source, the coil 224 causes the ATM main body 223 to float with respect to the ground.

A metal portion in the ATM main body 223 is in contact with the antenna element E1. The metal frame 222 serves as the antenna element E2. Therefore, when the electric field sensor device 101 is configured and a person approaches the ATM 221 (antenna element E2), the voltage of the electric field sensor device 101 increases. Furthermore, when a person moves away from the ATM 221, the voltage of the electric field sensor device 101 drops. Note that the present technology can also be applied to a vending machine similarly to the ATM.

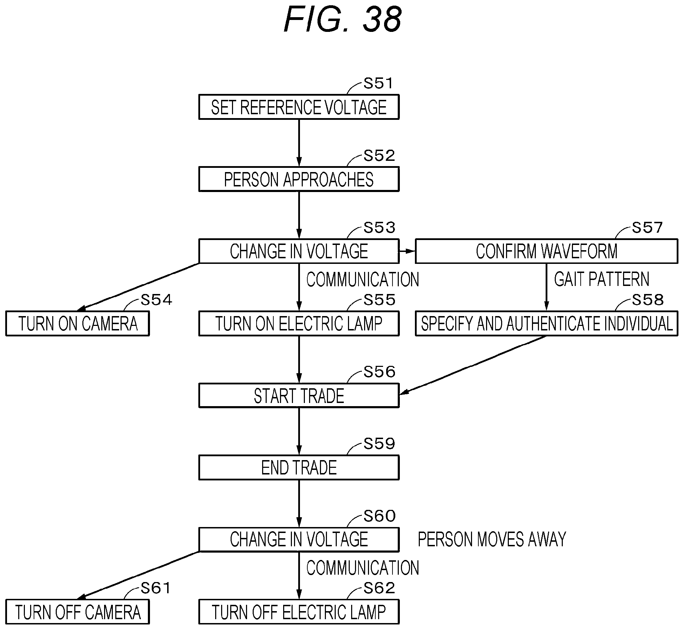

The operation of the configuration of Figs. 36 and 37 will be described with reference to the flowchart of Fig. 38.

Step S51: A reference voltage is set. That is, the voltage of the electric field sensor device 101 in a state where the electric light installed near the ATM 221 is turned off and there is no person is set as the reference voltage. By storing the set reference voltage in the storage unit, it is not necessary to repeat the setting of the reference voltage.

Step S52: A person approaches the ATM 221.

Step S53: Whether a person approaches is determined from a voltage change. When a person approaches, the voltage of the electric field sensor device 101 increases with respect to the reference voltage.

Steps S54 and S55: When it is determined that a person approaches, the camera provided in the ATM 221 is turned on, capturing of the person is started, the determination result is transmitted to the lighting device, and the electric light is turned on.

Step S56: A transaction using the ATM 221 is started. Operations and processes such as input of a personal identification number, fingerprint authentication, insertion of an IC card, input of an amount of money, and cash deposit/payment are performed. For the personal authentication, a change in voltage of the electric field sensor device 101 can be used.

Step S57: A waveform of a change in voltage when a person approaches the ATM 221 is confirmed. This waveform is different for each person, and thus becomes a gait pattern. The gait pattern is a change in voltage generated when a person who is a conductor walks, and has a unique waveform due to the spinal cord reflex of the person. By observing this waveform, it is possible to identify an individual.

Step S58: The gait pattern is analyzed, and an individual approaching the ATM 221 is identified from the gait pattern, and authentication is performed. In a case where the authentication is established, the transaction is allowed to start. In this case, establishment of authentication is comprehensively determined in combination with results of other authentication means.

Step S59: After the authentication is established, transactions such as input of an amount of money, cash deposit/payment, and passbook entry are performed, and the transaction is terminated.

Step S60: A person separates from the ATM 221, and the voltage of the electric field sensor device 101 drops to the reference voltage.

Steps S61 and S62: When it is determined that the person has moved, the camera provided in the ATM 221 is turned off, capturing of the person is terminated, the determination result is transmitted to the lighting device, and the electric light is turned off.

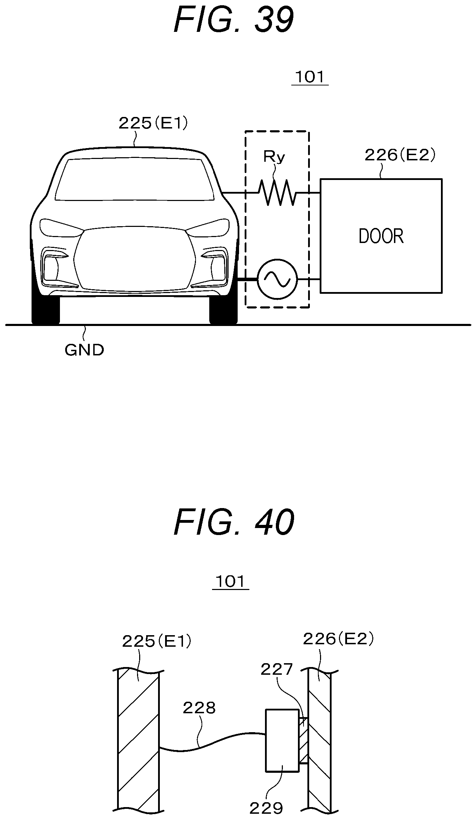

Fig. 39 illustrates an application example to a car. Since the car is a conductor, the car is not limited to a detection target, and the car can be used as an antenna element of the electric field sensor device. An embodiment will be schematically illustrated in which the electric field sensor device 101 is configured using a metal portion (simply referred to as a car body as appropriate) 225 of a frame, a body, or the like of a car in which a noise source exists as the antenna element E1 and a metal portion (simply referred to as a car door as appropriate) 226 of a door of a car that is not grounded to the earth ground as the antenna element E2.

In this case, the antenna element E1 is capacitively coupled to the ground via a space to acquire electric field energy. This can still be used sufficiently, but the induced voltage level will be small. In order to improve that part, the car door 226 is connected to the car body 225 with a noise source at different potentials, and the car is divided into two antenna elements. Only the car door 226 can be used as a sensor. Note that since there is a plurality of car doors 226, each door may be set as a separate sensor. By using each door as a sensor, a door to which a person approaches can be specified.

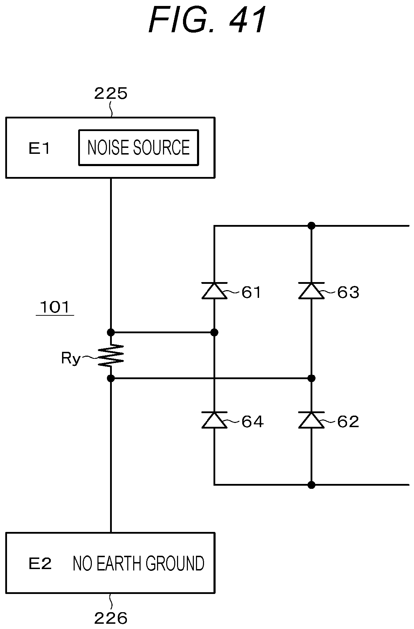

As illustrated in Fig. 40, a circuit unit 229 of the electric field sensor device 101 is attached to the car door 226 via a contact portion 227 of the conductor, and is electrically connected to the car body 225 having a potential different from that of the car door by a cable 228. The circuit unit 229 includes a rectifier circuit 2, a power storage unit 3, a detection unit 5, and a communication unit 6. In this case, the separation resistor Ry of 10 kΩ or more may be inserted between the car body 225 and the door 226. The circuit configuration in this case is as illustrated in Fig. 41, and two input terminals of the rectifier circuit including the diode 61 to 64 are connected to both ends of the separation resistor Ry.

In this embodiment, in the electric field sensor device 101, the antenna element E2 operates as a human sensor. That is, in a case where the person approaches the antenna element E2 (car door 226), the antenna element E2 and the person are coupled by capacitance, the antenna size increases, and more energy of the electric field in the space is taken in. Furthermore, as the distance between the antenna element E2 and the person becomes shorter, the coupling also becomes stronger. As a result, the voltage induced in the electric field sensor device 101 increases. Furthermore, since the antenna element E2 can have a relatively large size in order to use the car door 226 as an antenna, the antenna element E2 has a larger size than the antenna element made of another member, and has a larger capacitance with an approaching conductor, so that there is an advantage that the sensor sensitivity is improved.

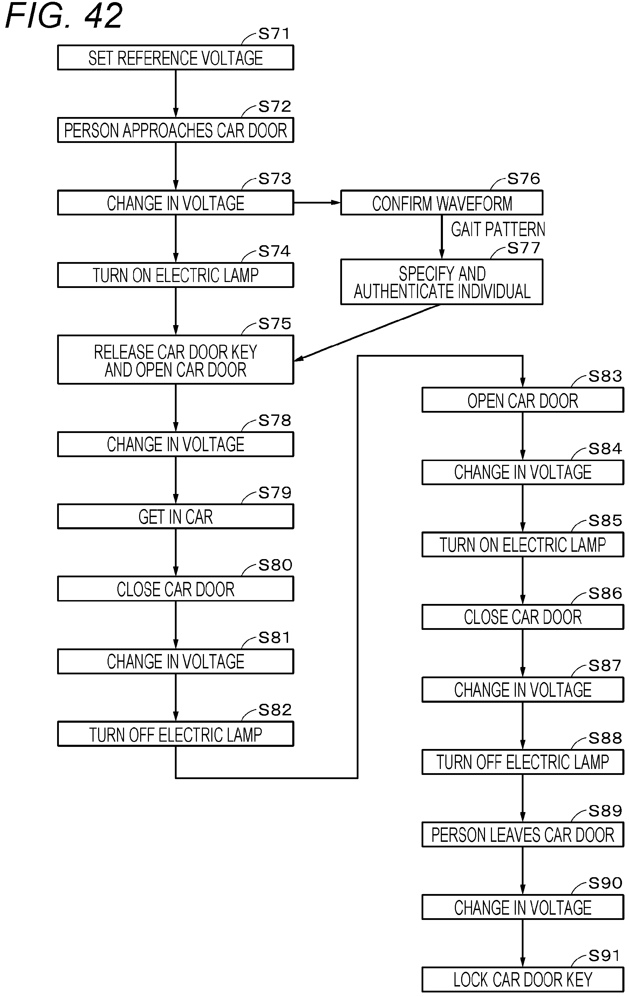

Fig. 42 is a flowchart illustrating a flow of processing of the detection unit of the electric field sensor device 101. As an example, it is a flow until a person approaches a car door and gets on the car and then gets off the car.

Step S71: A voltage in a state where no person is near the car door 226 is preset as a reference voltage. By storing the set reference voltage in the storage unit, it is not necessary to repeat the setting of the reference voltage.

Step S72: A person approaches the car door 226.

Step S73: A change in voltage of the electric field sensor device 101 is detected. When an increase in voltage is detected, it is determined that a person has approached.

Step S74: In a case where approach of a person is detected, a detection result is transmitted to the control unit of the car, and the light in the car is turned on.

Step S75: Moreover, the door key of the car is released, and a person opens the door.

Step S76: A waveform of a change in voltage when a person approaches the door 226 is confirmed. This waveform is different for each person, and thus becomes a gait pattern. The gait pattern is analyzed, an individual approaching is identified from the gait pattern, and authentication is performed. In a case where the authentication is established, the door key can be released in step S75.

Step S78: A voltage change occurs in the electric field sensor device 101.

Step S79: A person rides in a car.

Step S80: A person closes the car door 226.

Step S81: A voltage change occurs in the electric field sensor device 101. Since the interval between the person and the car door 226 increases, the voltage decreases.

Step S82: When a decrease in voltage is detected, it is determined that a person has got on the car. The determination result is transmitted to the control unit of the car, and the light in the car is turned off.

Step S83: A person opens the car door 226 to get off.

Step S84: A voltage change occurs in the electric field sensor device 101. Since the interval between the person and the car door 226 is narrowed, the voltage increases.

Step S85: When an increase in voltage is detected, a detection result is transmitted to the control unit of the car, and a light in the car is turned on.

Step S86: The car door is closed.

Step S87: A voltage change occurs in the electric field sensor device 101. Since the interval between the person and the car door 226 increases, the voltage drops.

Step S88: When the voltage drop is detected, the detection result is transmitted to the control unit of the car, and the light in the car is turned off.

Step S89: A person leaves the car door 226.

Step S90: A voltage change occurs in the electric field sensor device 101. Since the interval between the person and the car door 226 further increases, the voltage further drops to become the reference voltage.

Step S91: When it is detected that the reference voltage has been reached, a detection result is transmitted to the control unit of the car, and the door key of the car is locked.

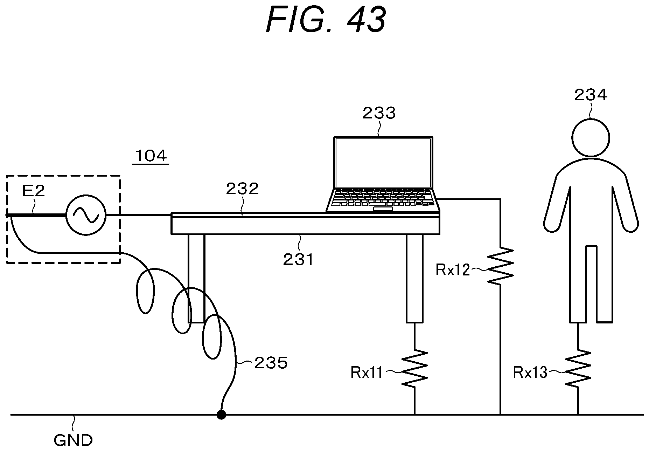

Next, an embodiment in which the present technology is applied to a sensor in an office will be described with reference to Figs. 43, 44, and 45. Fig. 43 schematically illustrates the periphery of a desk 231 in an office. The desk 231 is made of metal, and a conductive desk mat 232 is placed on the desk 231. Since the desk mat 232 is placed, a desk using a non-metallic material such as wood can also be used as the desk 231. Moreover, a notebook PC 233 is placed on the desk 231. Note that the present technology can be applied not only to a desk but also to a metal rack.

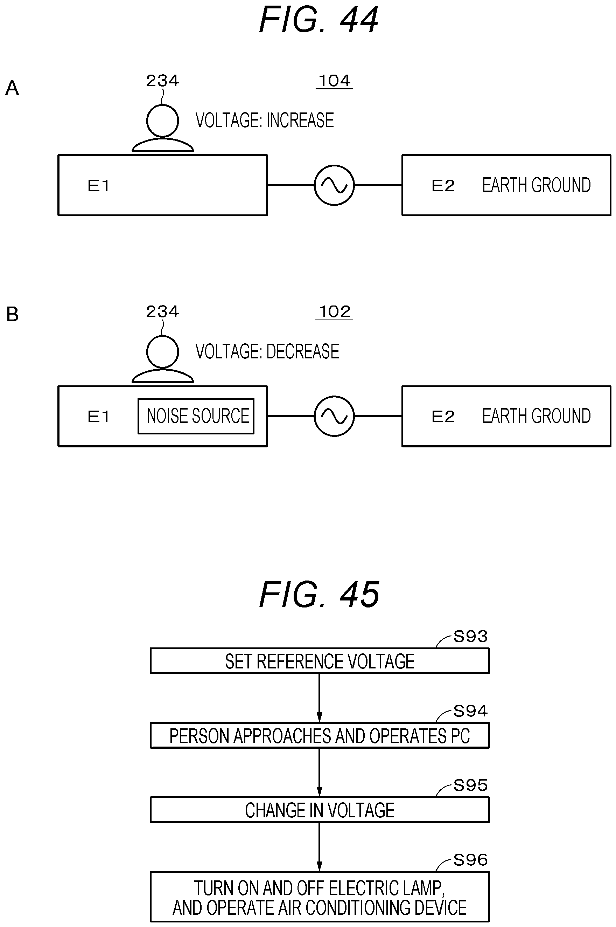

As illustrated in Fig. 44A, a metal plate, an electrode, a meander antenna, and the like of the electric field sensor device 104 illustrated in Fig. 24 constitute the antenna element E2. The antenna element E2 is grounded to the earth ground of the office via a cable 235. The desk 231 is grounded to the earth ground via a ground resistor Rx11, and the notebook PC 233 is grounded to the earth ground via a ground resistor Rx12. Moreover, a resistor Rx13 exists between a person 234 and the ground.

As illustrated in Fig. 44A, the desk mat 232 functions as the antenna element E1 of the electric field sensor device 104. In a case where the desk 231 is made of metal, the desk 231 also functions as the antenna element E1. In a case where there is no noise source on the desk 231, the desk 231 and the desk mat 232 function as sensors of the electric field sensor device 104.

Even if the notebook PC 233 is simply placed on the desk 231, the notebook PC 233 does not become a noise source. However, in a case where the notebook PC 233 is powered on and in a case where the notebook PC 233 is being charged, noise is generated from the notebook PC 233. In this case, as illustrated in Fig. 44B, there is a noise source in the antenna element E1, and the electric field sensor device 102 illustrated in Fig. 24 is configured.

In the case of the electric field sensor device 104 illustrated in Fig. 44A, when the person 234 approaches or comes into contact with the desk 231, the desk 231 and the person 234 are coupled, the size of the antenna element E1 substantially increases, and the voltage of the electric field sensor device 104 increases. Similarly, in a case where the notebook PC 233 is simply placed on the desk 231, that is, in a case where power is not supplied to the notebook PC 233, the approach of a person is detected by detecting an increase in voltage.

On the other hand, in a case where power is supplied to the notebook PC 233, the notebook PC 233 serves as a noise source, and the electric field sensor device 102 is configured as illustrated in Fig. 44B. In the case of the electric field sensor device 102, when the person 234 approaches or comes into contact with the desk 231, the noise is diverted to the person 234, so that the voltage of the electric field sensor device 102 decreases.

In the flowchart of Fig. 45, the reference voltage is set in advance in step S93. As the reference voltage, the voltage of the electric field sensor device 104 in a state where the electric light in the office is turned off, there is no noise source such as the notebook PC 233, and the person 234 is not near the desk 231 is set as the reference voltage. By storing the set reference voltage in the storage unit, it is not necessary to repeat the setting of the reference voltage.

Step S94: A person approaches the desk 231 or power is supplied to the notebook PC 233.

Step S95: A change in voltage (either rising or falling) is detected.

Step S96: The detection result is transmitted to the control device of the electric light, and the electric light is turned on by the control device. Furthermore, the detection result is transmitted to the control device of the air conditioning device, and the air conditioning device is turned on by the control device. Note that in a case where a person moves away from the desk 231 or stops the power supply to the notebook PC 233, the electric light in the office is turned off and the air conditioning device is turned off by the detection of the change in voltage.

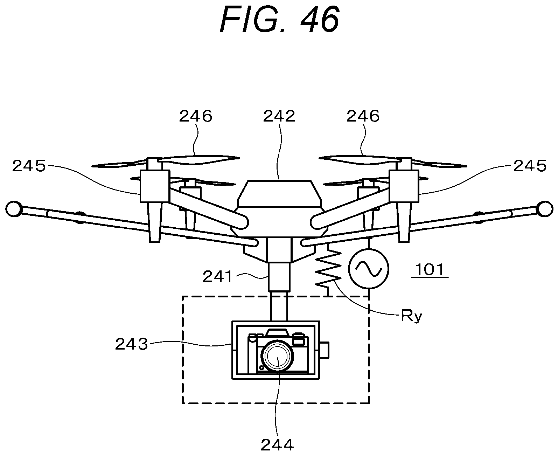

Next, an embodiment in which the present technology is applied to a drone will be described with reference to Figs. 46, 47, 48, and 49. Fig. 46 illustrates an example of a drone. A main body portion 242 is attached to an upper portion of a metal body part 241, and an imaging device 244 is attached to a metal frame 243 in a lower portion of the body part 241.

The main body portion 242 houses a control unit, a battery unit as a power source, and the like in the metal case. A circuit unit of the electric field sensor device 101 is provided in the main body portion 242. A plurality of support shafts extending substantially horizontally from the main body portion 242 is provided, and a motor 245 as a drive source of a rotor blade 246 is attached to a distal end surface of each of the support shafts. The rotor blade 246 is attached to the rotor shaft of the motor 245. A motor control circuit for controlling each motor is provided in the main body portion 242. The drone is remotely controlled by a controller on the ground.

The drone is divided into an upper configuration and a lower configuration by inserting a separation resistor Ry of 10 kΩ or more between the upper configuration including the main body portion 242, the motor 245, and the rotor blade 246 and the lower configuration including the metal frame 243. The upper configuration is an antenna element E1 having a noise source, and the lower configuration is an antenna element E2 (not grounding to the earth ground). The rectifier circuit 2 of the electric field sensor device 101 and the circuit unit such as a detection unit 5 are housed in the main body portion 242. The antenna element E2 is used as a sensor.

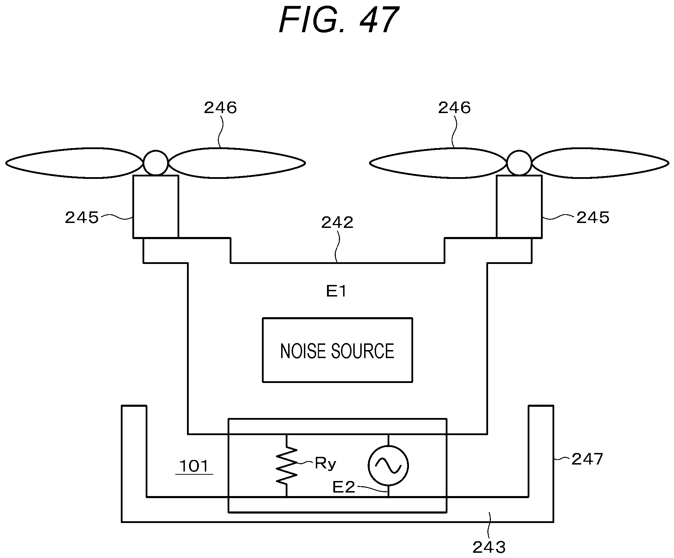

An outline of the electric field sensor device 101 is illustrated in Fig. 47. In Fig. 47, a side surface 247 of the metal frame 243 is extended upward (or downward) to increase the antenna size, so that the sensitivity of the side surface of the sensor is improved. The electric field sensor device 101 can detect a high-voltage line approaching the front surface in the traveling direction of the drone.

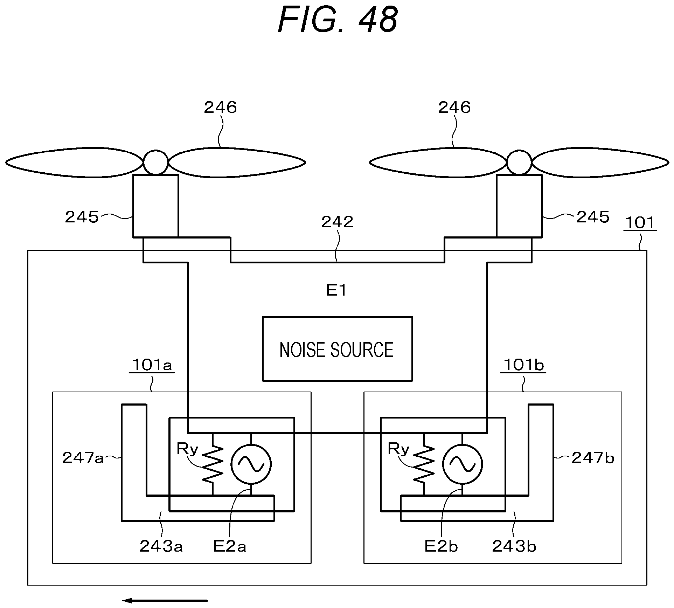

Moreover, as illustrated in Fig. 48, the metal frame 243 may be divided into metal frames 243a (having side surface 247a) and 243b (having side surfaces 247b), and electric field sensor devices 101a and 101b may be provided. One electric field sensor device 101a detects a high-voltage line ahead in the traveling direction indicated by the arrow, and the other electric field sensor device 101b detects a high-voltage line in the direction opposite to the traveling direction. As described above, by providing the electric field sensor devices 101a and 102b, it is possible to detect not only the presence or absence of the high-voltage line but also the direction in which the high-voltage line exists.

The drone has an imaging device 244, and can perform remote control so as to avoid an obstacle when imaging the obstacle during flight. However, in a case where conditions such as brightness are not good, a high-voltage line may not be recognized as an obstacle. Since a leakage electric field exists around the high-voltage line, the electric field sensor device 101 (101a, 101b) can detect that the high-voltage line is close by detecting the leakage electric field, and can avoid contact with the high-voltage line on the basis of the information.

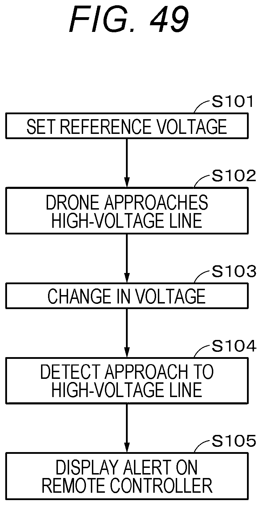

Fig. 49 is a flowchart for explaining the operation of the embodiment illustrated in Fig. 47 in which the present technology is applied to a drone.

Step S101: A reference voltage is set. The voltage of the electric field sensor device 101 in a state where the drone is operating and there is no leakage electric field of the high-voltage line is set to the reference voltage. By storing the set reference voltage in the storage unit, it is not necessary to repeat the setting of the reference voltage.

Step S102: The drone approaches the high-voltage line.

Step S103: A change in voltage of the electric field sensor device 101 is determined. In a case where the drone approaches the high-voltage line, the leakage electric field is detected and the voltage rises.

Step S104: The approach to the high-voltage line is detected by the increase in voltage, and the communication unit transmits the approach to the high-voltage line to the remote controller.

Step S105: The remote controller displays that the drone has approached the high-voltage line. In this case, an alarm may be generated. The remote controller is operated by looking at this display, and it is possible to prevent the drone from contacting the high-voltage line.

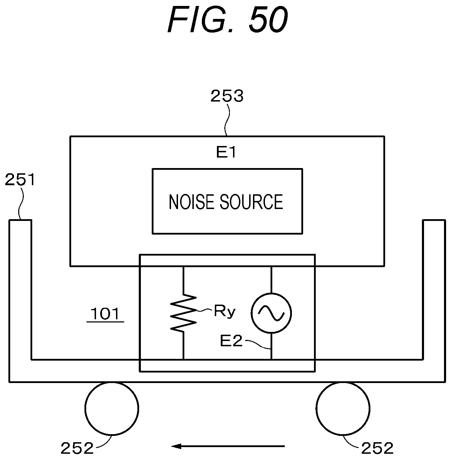

Next, with reference to Figs. 50, 51, and 52, an embodiment in which the present technology is applied to a transfer robot, for example, a transfer robot that tows an existing carriage on a set route will be described. As schematically illustrated in Fig. 50, the transfer robot includes a metal frame 251 having wheels 252, and a metal main body portion 253 that is located above the frame 251 and houses a motor for driving the wheels 252, a power supply circuit, a control unit, a communication unit, and the like.

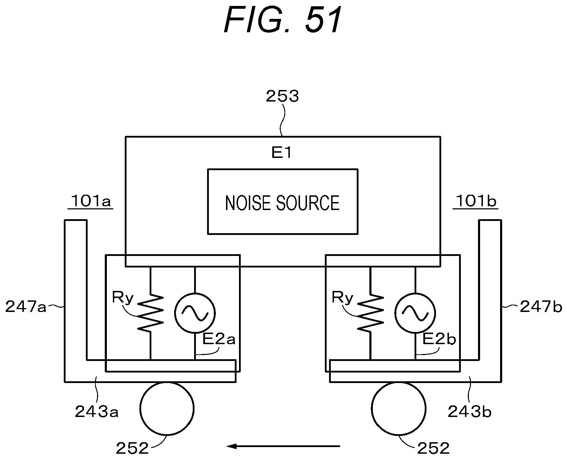

The electric field sensor device 101 includes a frame 251 as an antenna element E1 and a main body portion 253 as an antenna element E2. The antenna element E1 includes a noise source such as a motor. Furthermore, the separation resistor Ry is inserted between the frame 251 and the main body portion 253. For example, front and rear end surfaces of the frame 251 in a traveling direction indicated by an arrow are raised to an upper portion, and sensitivity of the sensor is improved. The electric field sensor device 101 detects an obstacle (person, metal object, and the like) ahead in the traveling direction of the transfer robot. Moreover, as illustrated in Fig. 51, the electric field sensor devices 101a and 101b may be provided to detect a direction in which an obstacle exists.

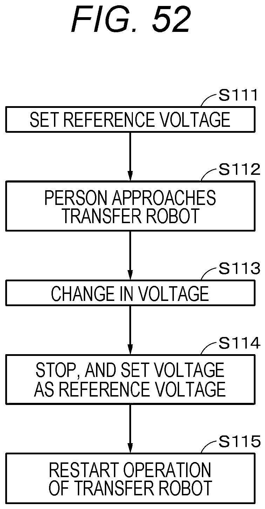

Fig. 52 is a flowchart for explaining the operation of the embodiment in which the present technology is applied to a transfer robot.

Step S111: A reference voltage is set. The voltage of the electric field sensor device 101 in a state where the transfer robot is in the traveling state and the obstacle is not approaching is set to the reference voltage. By storing the set reference voltage in the storage unit, it is not necessary to repeat the setting of the reference voltage.

Step S112: The transfer robot approaches an obstacle, for example, a person.

Step S113: A change in voltage of the electric field sensor device 101 is determined. In a case where a person approaches the transfer robot, the voltage increases.

Step S114: It is detected that a person approaches due to an increase in voltage, and the transfer robot is stopped. The transfer robot is stopped, and the voltage is reset to the reference voltage.

Step S115: The transfer operation of the transfer robot is restarted. In this way, contact of the transfer robot with a person is avoided.

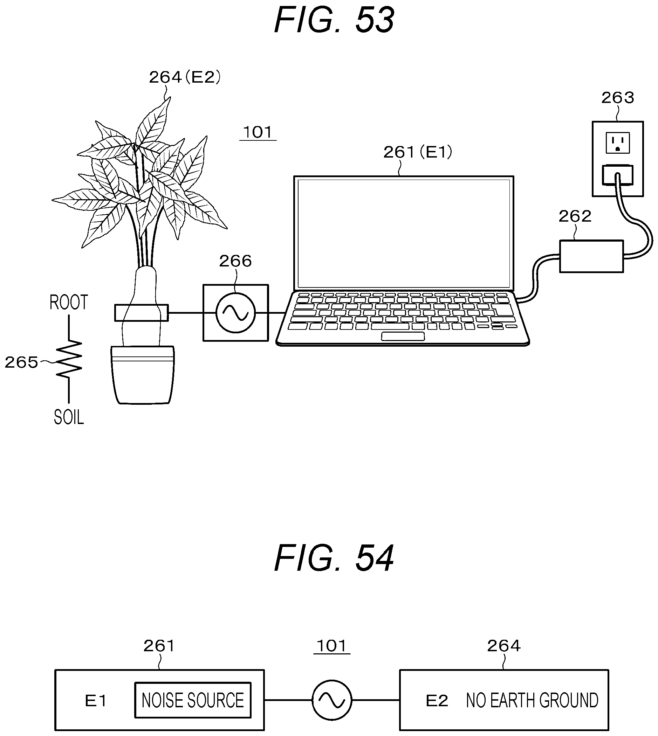

Next, an embodiment in which a potted plant 264 such as a foliage plant is used as the antenna element E2 will be described with reference to Fig. 53. For example, the potted plant 264 is placed at the reception of the company. A power adapter 262 is used for charging a notebook PC 261, and the power adapter 262 is connected to an outlet 263 of commercial power. The notebook PC 261 is set to the antenna element E1 having a noise source.

The potted plant 264 has sap that is an electrolytic solution, and can be used as a conductor (antenna element). The root of the potted plant 264 is connected to the soil (earth) via an equivalent resistor 265 corresponding to the amount of moisture in the soil. Therefore, as illustrated in Fig. 54, the electric field sensor device 101 is configured. A circuit unit 266 of the electric field sensor device 101 is connected to the notebook PC 261 and the potted plant 264. The circuit unit 266 includes a rectifier circuit 2, a power storage unit 3, a detection unit 5, and a communication unit 6. The notebook PC 261 which is the antenna element E1 or the potted plant 264 which is the antenna element E2 is used as the sensor. The equivalent resistor 265 decreases when water is supplied, and the connection with the ground increases, and the voltage of the electric field sensor device 101 increases.

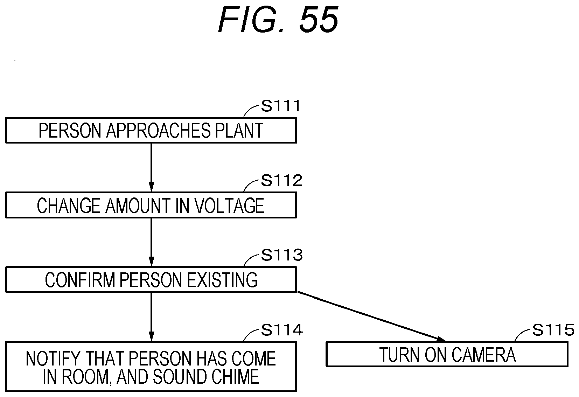

Fig. 55 is a flowchart for explaining an operation in a case where the potted plant 264 is used as a human sensor in the embodiment illustrated in Figs. 53 and 54.

Step S111: A person approaches the potted plant 264.

Step S112: A change in voltage of the electric field sensor device 101 is detected. The value of the voltage of the electric field sensor device 101 in the case of the absence of a person differs depending on the equivalent resistor 265 of the potted plant 264. When the potted plant 264 has a large amount of moisture, the value of the equivalent resistor 265 is relatively small, and the voltage in a state where no person is present is relatively large. On the other hand, when the amount of moisture is small, the value of the equivalent resistor 265 is relatively large, and the voltage in a state where no person is present is relatively small. In either case, when a person approaches, the voltage of the electric field sensor device 101 increases.

Step S113: In a case where it is determined that the voltage change detected in step S112 is an increase, it is recognized that a person approaches (is at reception).

Step S114: The recognition result is transmitted to the reception system, and it is notified that a person has come. For example, a chime is sounded.

Step S115: The recognition result is transmitted to the reception system, and photographing by an image-capturing device installed near the reception is started.

Note that the notebook PC 261 (antenna element E1) side may be used as the sensor. In this case, when the person approaches the notebook PC 261, the noise from the noise source is diverted to the person, and the voltage of the electric field sensor device 101 changes in the decreasing direction. By detecting this voltage change, it is recognized that a person has come to reception.

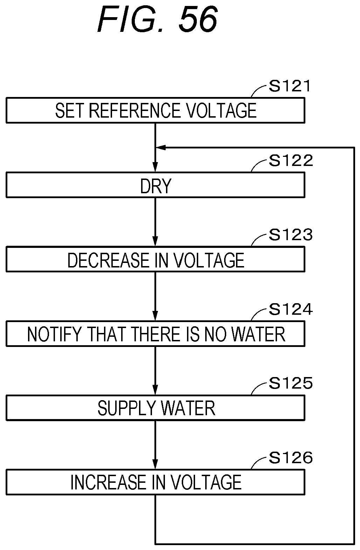

Moreover, the embodiment of Fig. 53 can be applied to the management system of a rehydration season for the potted plant 264. The flow of processing in that case is illustrated in the flowchart of Fig. 56.

Step S121: A reference voltage is set. The voltage of the electric field sensor device 101 in a case where the moisture supplied to the potted plant 264 is appropriate is set to the reference voltage. By storing the set reference voltage in the storage unit, it is not necessary to repeat the setting of the reference voltage.

Step S122: The potted plant 264 is dried to be in a state of insufficient moisture.

Step S123: Since the equivalent resistor 265 becomes large, the coupling with the ground is weakened, and the voltage of the electric field sensor device 101 decreases.

Step S124: When the voltage is lower than a predetermined value, a person in charge of water supply is notified that there is no water.

Step S125: Water supply is performed in response to this notification. Note that the water supply is not limited to a human method, and an automatic method using a water supply device is also possible.

Step S126: The equivalent resistor 265 is decreased by the water supply, and the voltage of the electric field sensor device 101 is increased. Then, when the potted plant 264 is dried over time, the process returns to step S122.

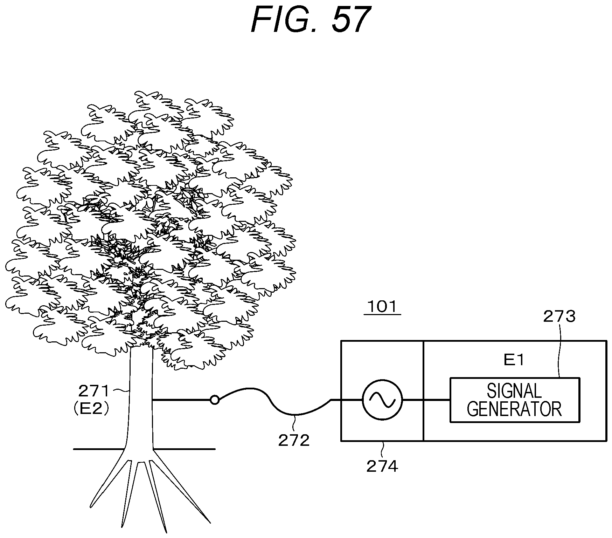

Fig. 57 illustrates the electric field sensor device 101 in which a tree 271 planted on the ground is used as an antenna element E2. A cable 272 is connected to the tree 271, and the antenna element E1 and the tree 271 (antenna element E2) constitute an antenna device. A signal generator 273 is provided as a noise source for the antenna element E1. A circuit unit 274 of the electric field sensor device 101 is connected to the signal generator 273 and the tree 271. The circuit unit 274 includes a rectifier circuit 2, a power storage unit 3, a detection unit 5, and a communication unit 6.

The ground resistor of the tree 271 changes depending on the amount of moisture in the soil, and the degree of coupling between the ground and the tree 271 (antenna element E2) changes. In a case where the amount of moisture is large, the ground resistor becomes small, the coupling of the antenna element E2 with the ground becomes strong, and the voltage of the electric field sensor device 101 becomes large. On the other hand, in a case where the amount of moisture is small, the ground resistor becomes large, the coupling of the antenna element E2 with the ground becomes weak, and the voltage of the electric field sensor device 101 becomes small. In this manner, the amount of moisture in the ground can be detected from the voltage of the electric field sensor device 101. Power to the electric field sensor device 101 and the signal generator 273 is supplied from, for example, a solar cell (not illustrated).

Data of the detected amount of moisture is transmitted to a moisture amount monitoring system by the communication device. The moisture amount monitoring system receives data of the amount of moisture of a place where a plurality of trees is planted and predict a risk of occurrence of a disaster such as collapse of soil. Furthermore, it is also possible to detect tree growth, illness, or the like by a change in the electrolytic solution of the tree. Moreover, as described with reference to Fig. 53, it is also possible to appropriately supply irrigation, fertilizer, and the like in a case where the amount of moisture is insufficient.

Moreover, when a rectangular wave of 2 V is applied to the antenna element E1, for example, at a frequency of 1 kHz from the signal generator 273 as a noise source connected to the antenna element E1, a signal corresponding to the frequency and voltage applied to the antenna element E1 is induced as an image from the antenna element E2 connected to the plant. In the antenna element E2, since the power corresponding to the signal input to the antenna element is induced in this manner, by appropriately selecting the frequency and the electric energy, it is possible to expect a pest control effect of not attracting a harmful insect to the plant.

Furthermore, the electrical stimulation induced in the plant becomes moderate stress on the plant, and an effect of increasing sugar content can also be expected for vegetables such as tomatoes and fruits such as grapes. The GND of the signal generator 273 may be connected to the same soil as the plant.

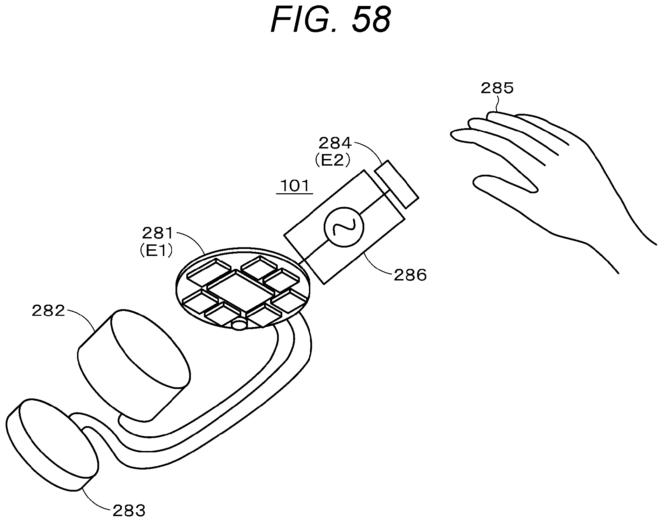

The present technology can be applied to a motion sensor of a part such as a human hand. Fig. 58 is an exploded perspective view for explaining an embodiment in which the present technology is applied to a sensor that is provided in a mobile electronic device, for example, wireless headphones and detects a motion of a hand. Since the synthetic resin housing of the wireless headphone is not a conductor, the wireless headphone is insulated from a person.

In the housing, a main board 281, a lithium ion secondary battery 282, and a speaker driver 283 are housed. An electrode in the main board 281 is used as the antenna element E1. On the main board 281, for example, a communication circuit of Bluetooth (registered trademark), an amplifier for driving the speaker driver 283, a charge/discharge control circuit of the lithium ion secondary battery 282, and the like are mounted.

Since noise associated with signal processing is generated in the main board 281, the antenna element E1 has a noise source. Furthermore, an electrode 284 is attached to the housing, and the electrode 284 is used as the antenna element E2. The antenna element E2 is not grounded to the earth ground. Therefore, the antenna element E1 and the antenna element E2 constitute the electric field sensor device 101. The antenna element E2 is used as a sensor of a hand 285. A circuit unit 286 of the electric field sensor device 101 is connected to the electrode in the main board 281 and the electrode 284. The circuit unit 286 includes a rectifier circuit 2, a power storage unit 3, a detection unit 5, and a communication unit 6.

As illustrated in Fig. 58, the electric field sensor device 101 can detect that the hand 285 of the person wearing the headphones approaches the electrode 284. Therefore, since the voltage of the electric field sensor device 101 changes when the hand 285 approaches, the operation of the headphones can be controlled on the basis of the voltage change. Moreover, by providing a plurality of electric field sensor devices, it is possible to detect a direction in which the hand 285 approaches, and more types of control can be performed.

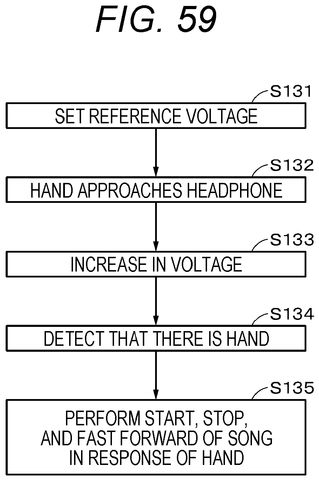

Moreover, a flow of processing of the embodiment of Fig. 58 is illustrated in a flowchart of Fig. 59.

Step S131: A reference voltage is set. The voltage of the electric field sensor device 101 when the headphone is worn on the ear and the hand 285 is not present near the headphone is set as the reference voltage. By storing the set reference voltage in the storage unit, it is not necessary to repeat the setting of the reference voltage.

Step S132: The hand 285 approaches the headphones (electrodes 284).

Step S133: The electrode 284 and the hand 285 are spatially coupled, the electric field energy to be taken in increases, and the voltage of the electric field sensor device 101 increases.

Step S134: As the voltage of the electric field sensor device 101 rises from the reference voltage, it is detected that the hand 285 has approached. The detection result is transmitted to the control unit of the headphone.

Step S135: The control unit controls the reproducing operation of the headphones on the basis of the detection of the hand 285. For example, since the movement of the hand can be detected by providing a plurality of electrodes 284, that is, control such as start of reproduction, stop of reproduction, and fast forward of songs is performed.

In the above embodiment, by using the product metal portion as an antenna, it is possible to take in more energy of the quasi-electrostatic field and the radio wave generated in the space. Moreover, it is possible to convert power and noise leaking from the power cord and the inverter into energy. If the taken-in energy is rectified and stored in an energy storage device such as a secondary battery, the energy can be used as a power source of an electric field sensor device, and thus the energy can be efficiently utilized. Therefore, it may be related to Goal 7 "Affordable and Clean Energy" of Sustainable Development Goals (SDGs) adopted at the UN summit in 2015.

Although the embodiments of the present technology have been specifically described above, the present technology is not limited to the above-described embodiments, and various modifications based on the technical idea of the present technology can be made. Furthermore, one or a plurality of arbitrarily selected aspects can be appropriately combined. Furthermore, the configurations, methods, steps, shapes, materials, numerical values, and the like of the above-described embodiments can be combined with each other without departing from the gist of the present technology. For example, power generation using the present technology and natural energy, for example, solar power generation or a thermoelectric conversion element may be used in combination to store energy.

Note that, the present technology may also have the following configuration.
(1) An electric field sensor device including:
   an antenna device that has a dipole structure that receives an electric field, the antenna device including a first antenna element connected to or in contact with a ground and a conductor existing with a certain resistance value, and a second antenna element grounded to an earth ground or not grounded to an earth ground;
   a rectifier circuit that rectifies a signal induced in the antenna device; and
   a detection unit that detects a level of an output voltage of the rectifier circuit, in which
   the detection unit detects a change in level of the output voltage caused when the first antenna element or the second antenna element not grounded to an earth ground is spatially coupled to or in contact with another conductor different from the conductor, and detects a state or a situation of the other conductor.
(2) The electric field sensor device according to (1), in which a noise source is present in the first antenna element.
(3) The electric field sensor device according to (1) or (2), in which a resistor having a resistance value of 10 kΩ or more exists between the conductor and a ground.
(4) The electric field sensor device according to any one of (1) to (3), in which the conductor is divided into at least first and second conductors with a resistor of 10 kΩ or more, and the first antenna element and the second antenna element are configured by the divided first and second conductors.
(5) The electric field sensor device according to any one of (1) to (4), in which the rectifier circuit is a half-wave or full-wave rectifier circuit.
(6) The electric field sensor device according to (5), in which a rectifying diode used in the rectifier circuit is made of silicon having a small leakage current at a time of counter electromotive force.
(7) The electric field sensor device according to (1), in which the other conductor is any one of a personal computer, a car, a high-voltage line, a human body, and a living organism (an animal and a plant other than a human).
(8) The electric field sensor device according to (1), further including a power storage unit that charges electric power output from the rectifier circuit.
(9) The electric field sensor device according to (1), further including a communication means that is used to transmit information obtained from the detection unit to another device.
(10) The electric field sensor device according to (1), in which in the first antenna element according to (1), the first antenna element is connected to a ground via a cable.
(11) The electric field sensor device according to (1), in which the first antenna element includes a metal conductor such as an electric refrigerator, a vending machine, an ATM, a transfer robot, a metal desk, or a metal rack.
(12) The electric field sensor device according to (1), in which
   the first antenna element is a conductor having a noise source, and the second antenna element is a potted plant that is not grounded to an earth ground, and
   an approach of a human body to the potted plant is detected by a change in level of the output voltage caused by spatial coupling or contact between the potted plant and the human.
(13) The electric field sensor device according to (1), in which
   the first antenna element is a conductor having a noise source, and the second antenna element is a tree in soil, and
   a change in an amount of moisture is detected by a change in level of the output voltage caused by a change in the amount of moisture contained in the tree.
(14) The electric field sensor device according to (1), in which
   the first antenna element is a conductor having a signal generator, and the second antenna element is a plant planted in soil, and
   a signal from the signal generator is induced in the plant.
(15) The electric field sensor device according to (1), in which
   the first antenna element is a conductor having a noise source, and the second antenna element is an electrode provided in an electronic device,
   an approach of a part of a human body with the electrode is detected by a change in level of the output voltage, and
   an operation of the electronic device is controlled on a basis of the detection.

### REFERENCE SIGNS LIST

- 1: Antenna device
- 2: Rectifier circuit
- 3: Power storage unit
- 4: Harvester
- 5: Detection unit
- 6, 7: Communication unit
- 8: Control unit
- 11: Conductive member
- 15: Feeding point
- 19: Ground electrode
- 20A, 20B, 20C: Antenna element
- 101, 102, 103, 104: Electric field sensor device
- 105: Electric refrigerator
- 201: Person
- 202: Car
- 211: Fluorescent lamp device
- 212: Warm-water cleaning toilet seat
- 221: ATM
- 225: Car body
- 226: Car door
- 231: Desk
- 233: Notebook PC
- 242: Main body portion of drone
- 243: Metal frame of drone
- 251: Frame of transfer robot
- 253: Main body portion of transfer robot
- 264: Potted plant
- 271: Wood

## Claims

1. An electric field sensor device comprising:
an antenna device that has a dipole structure that receives an electric field, the antenna device including a first antenna element connected to or in contact with a ground and a conductor existing with a certain resistance value, and a second antenna element grounded to an earth ground or not grounded to an earth ground;
a rectifier circuit that rectifies a signal induced in the antenna device; and
a detection unit that detects a level of an output voltage of the rectifier circuit, wherein
the detection unit detects a change in level of the output voltage caused when the first antenna element or the second antenna element not grounded to an earth ground is spatially coupled to or in contact with another conductor different from the conductor, and detects a state or a situation of the other conductor.

2. The electric field sensor device according to claim 1, wherein a noise source is present in the first antenna element.

3. The electric field sensor device according to claim 1, wherein a resistor having a resistance value of 10 kΩ or more exists between the conductor and a ground.

4. The electric field sensor device according to claim 1, wherein the conductor is divided into at least first and second conductors with a resistor of 10 kΩ or more, and the first antenna element and the second antenna element are configured by the divided first and second conductors.

5. The electric field sensor device according to claim 1, wherein the rectifier circuit is a half-wave or full-wave rectifier circuit.

6. The electric field sensor device according to claim 5, wherein a rectifying diode used in the rectifier circuit is made of silicon having a small leakage current at a time of counter electromotive force.

7. The electric field sensor device according to claim 1, wherein the other conductor is any one of a personal computer, a car, a high-voltage line, a human body, and a living organism (an animal and a plant other than a human).

8. The electric field sensor device according to claim 1, further comprising a power storage unit that charges electric power output from the rectifier circuit.

9. The electric field sensor device according to claim 1, further comprising a communication means that is used to transmit information obtained from the detection unit to another device.

10. The electric field sensor device according to claim 1, wherein in the first antenna element according to claim 1, the first antenna element is connected to a ground via a cable.

11. The electric field sensor device according to claim 1, wherein the first antenna element includes a conductor such as an electric refrigerator, a vending machine, an ATM, a transfer robot, a metal desk, or a metal rack.

12. The electric field sensor device according to claim 1, wherein
the first antenna element is a conductor having a noise source, and the second antenna element is a plant that is not grounded to an earth ground, and
an approach of a human body to the plant is detected by a change in level of the output voltage caused by spatial coupling or contact between the plant and the human.

13. The electric field sensor device according to claim 1, wherein
the first antenna element is a conductor having a noise source, and the second antenna element is a plant planted in soil, and
a change in an amount of moisture is detected by a change in level of the output voltage caused by a change in the amount of moisture contained in the plant.

14. The electric field sensor device according to claim 1, wherein
the first antenna element is a conductor having a signal generator, and the second antenna element is a plant planted in soil, and
a signal from the signal generator is induced in the plant.

15. The electric field sensor device according to claim 1, wherein
the first antenna element is a conductor having a noise source, and the second antenna element is an electrode provided in an electronic device,
an approach or contact of a part of a human body with the electrode is detected by a change in level of the output voltage, and
an operation of the electronic device is controlled on a basis of the detection.
